# EUROPEAN PATENT APPLICATION

(11) **EP 4 764 040 A1**
(43) Date of publication of application: **24.06.2026**
(21) Application number: 24865274.5
(22) Date of filing: 30.08.2024
(51) Int. Cl.: C30B 29/36, C30B 23/02, C30B 33/12

(54) **METHOD FOR PROCESSING SIC SUBSTRATE, METHOD FOR REMOVING PROCESSING-AFFECTED LAYER OF SIC SUBSTRATE, AND METHOD FOR REDUCING SURFACE ROUGHNESS OF SIC SUBSTRATE**

(30) Priority: 15.09.2023 JP 2023150567
(71) Applicant: Kwansei Gakuin Educational Foundation, Nishinomiya-shi, Hyogo 662-8501 (JP); Toyota Tsusho Corporation, Nagoya-shi Aichi 450-8575 (JP)
(72) Inventor: KANEKO, Tadaaki, Sanda-shi, Hyogo 669-1330 (JP); TODA, Kohei, Sanda-shi, Hyogo 669-1330 (JP); DOJIMA, Daichi, Sanda-shi, Hyogo 669-1330 (JP)
(74) Representative: Schön, Christoph
(86) International application number: PCT/JP2024/031153
(87) International publication number: WO 2025/057772

(57) **Abstract**

To provide a novel processing method for a SiC substrate. Provided is a processing method for a SiC substrate, comprising an annealing step S2 of heating the SiC substrate 1 in an inert gas environment and an etching step S3 of etching the SiC substrate 1 that has undergone the annealing step S2 in an environment including a gas composed of one or both of Si element and C element.

## Description

### Technical Field

The present invention relates to a processing method for a SiC substrate.

### Background Art

In the manufacturing of SiC semiconductor devices, it is very important to process a SiC substrate sliced from an ingot (As-sliced substrate) and planarize the substrate surface at the atomic level. Conventional processing of SiC substrates has been to gradually reduce surface roughness by performing steps such as lapping and/or grinding (Lapping and/or Grinding) and polishing (Polishing).

However, it is known that mechanical damage remains in the SiC substrate processed in this manner. This damage manifests not only as scratches on the surface but also as crystal strain in the surface layer from the surface to a certain depth. A layer including these damages is called a "subsurface damaged layer," and has a large adverse effect on the performance of SiC semiconductor devices.

The present inventors have invented a method for reducing surface roughness by non-contact processing, unlike the various stages of conventional processing. Patent Literature 1 describes a method for reducing macro-step bunching on a substrate surface by etching by heating a SiC substrate in a vapor pressure environment of gas phase species including Si element and gas phase species including C element. Further, Patent Literature 2 describes a method for reducing a subsurface damaged layer of a substrate by etching by heating a SiC substrate in a vapor pressure environment of gas phase species including Si element and gas phase species including C element.

### Citation List

### Patent Literature

Patent Literature 1: International Publication No. WO 2020/179793
Patent Literature 2: International Publication No. WO 2020/179794

### Summary of Invention

### Technical Problem

The middle and final stages of conventional processing can be substituted by the methods described in Patent Literature 1 and Patent Literature 2. However, in the initial stage of processing, it is required to roughly reduce the surface roughness from a state where the surface roughness is very large. Therefore, it has been recognized in this technical field that the initial stage of processing must still be performed by contact processing such as grinding and polishing.

In such a situation, the present inventors have found the following problem. That is, it is the initial stage of processing that forms and expands a subsurface damaged layer in a SiC substrate, and as a result, makes it difficult to remove this subsurface damaged layer in the middle and final stages of processing. Further, material loss generated in the initial stage of processing is significant, and is a factor reducing the sustainability of SiC semiconductor device manufacturing.

Therefore, an object of the present invention is to provide a novel processing method for a SiC substrate. More specifically, an object is to provide a non-contact processing method capable of substituting the initial stage of conventional processing of a SiC substrate. Furthermore, an object is to provide a processing method capable of reducing material loss generated in the initial stage of this processing.

### Solution to Problem

One of the embodiments of the present invention for achieving the above object is a processing method for a SiC substrate, which is the following methods [1] to [82].

Method [1] is a processing method for a SiC substrate, comprising an annealing step of heating the SiC substrate in an inert gas environment and an etching step of etching the SiC substrate that has undergone the annealing step in an environment including a gas composed of one or both of Si element and C element. In Method [1], by strongly promoting both a sublimation reaction and a recrystallization reaction on the surface of the SiC substrate, atoms are vigorously exchanged between the surface layer of the SiC substrate and the environment, that is, metabolism of atoms constituting the surface layer of the SiC substrate can be strongly promoted. Thereby, a subsurface damaged layer included in the surface layer can be removed in a short time. Further, by the surface layer of the SiC substrate being leveled in the process of metabolism, a SiC substrate having small surface roughness is realized. Thereafter, by etching the SiC substrate, even if the SiC substrate has large surface roughness, a SiC substrate with significantly small surface roughness is realized by non-contact processing.

Method [2] is the processing method for a SiC substrate according to Method [1], wherein the annealing step includes heating the SiC substrate inside a crucible made of SiC, and in the annealing step, the inside of the crucible is maintained in an inert gas environment.

Method [3] is the processing method for a SiC substrate according to Method [1] or [2], wherein the annealing step includes etching one surface of the SiC substrate and, at the same time, growing the other surface of the SiC substrate.

Method [4] is the processing method for a SiC substrate according to Method [3], wherein the annealing step includes making a substrate thickness of the SiC substrate substantially the same before and after the annealing step by making an etching amount on one surface substantially the same as a growth amount on the other surface.

Method [5] is the processing method for a SiC substrate according to Method [3] or [4], wherein the annealing step includes increasing a substrate thickness of the SiC substrate before and after the annealing step by making an etching amount on one surface smaller than a growth amount on the other surface.

Method [6] is the processing method for a SiC substrate according to any one of Methods [2] to [5], wherein in the annealing step, the crucible comprises a base body having an opening and a lid, and the inside of the crucible is formed by covering the opening of the base body with the lid.

Method [7] is the processing method for a SiC substrate according to any one of Methods [2] to [6], wherein in the annealing step, the SiC substrate is supported by a substrate support.

Method [8] is the processing method for a SiC substrate according to any one of Methods [2] to [7], wherein in the annealing step, a pressure inside the crucible is 1 kPa or more.

Method [9] is the processing method for a SiC substrate according to any one of Methods [2] to [7], wherein in the annealing step, a pressure inside the crucible is 5 kPa or more.

Method [10] is the processing method for a SiC substrate according to any one of Methods [2] to [7], wherein in the annealing step, a pressure inside the crucible is 10 kPa or more.

Method [11] is the processing method for a SiC substrate according to any one of Methods [2] to [10], wherein in the annealing step, a temperature inside the crucible is 1800°C or more.

Method [12] is the processing method for a SiC substrate according to any one of Methods [2] to [10], wherein in the annealing step, a temperature inside the crucible is 2000°C or more.

Method [13] is the processing method for a SiC substrate according to any one of Methods [2] to [10], wherein in the annealing step, a temperature inside the crucible is 2200°C or more.

Method [14] is the processing method for a SiC substrate according to any one of Methods [2] to [13], wherein in the annealing step, a combination of pressure and temperature inside the crucible is a combination of 1 kPa or more and 1800°C or more.

Method [15] is the processing method for a SiC substrate according to any one of Methods [2] to [13], wherein in the annealing step, a combination of pressure and temperature inside the crucible is a combination of 5 kPa or more and 2000°C or more.

Method [16] is the processing method for a SiC substrate according to any one of Methods [2] to [13], wherein in the annealing step, a combination of pressure and temperature inside the crucible is a combination of 5 kPa or more and 2200°C or more.

Method [17] is the processing method for a SiC substrate according to any one of Methods [2] to [13], wherein in the annealing step, a combination of pressure and temperature inside the crucible is a combination of 10 kPa or more and 2200°C or more.

Method [18] is the processing method for a SiC substrate according to any one of Methods [2] to [17], wherein in the annealing step, a temperature gradient is formed inside the crucible in a direction penetrating the SiC substrate.

Method [19] is the processing method for a SiC substrate according to Method [18], wherein in the annealing step, the temperature gradient is formed in a sense such that the temperature decreases from a C face side toward a Si face side of the SiC substrate.

Method [20] is the processing method for a SiC substrate according to any one of Methods [2] to [19], wherein the annealing step comprises an accommodating step of accommodating the SiC substrate inside the crucible, in the annealing step, the crucible comprises a base body having an opening and a lid, and the accommodating step includes accommodating the SiC substrate inside the crucible by putting the SiC substrate through the opening of the base body and placing the lid on the base body to cover the opening of the base body.

Method [21] is the processing method for a SiC substrate according to any one of Methods [2] to [20], wherein the annealing step comprises an accommodating step of accommodating the SiC substrate inside the crucible, and the accommodating step includes supporting the SiC substrate in midair inside the crucible with a substrate support.

Method [22] is the processing method for a SiC substrate according to any one of Methods [2] to [21], wherein the annealing step comprises a heating step of heating the crucible, and the heating step includes heating the crucible to generate a source gas composed of one or both of Si element and C element from the crucible into the inside of the crucible.

Method [23] is the processing method for a SiC substrate according to any one of Methods [2] to [22], wherein the annealing step comprises a heating step of heating the crucible, and the heating step includes introducing an inert gas into the inside of the crucible and maintaining a pressure inside the crucible at 1 kPa or more.

Method [24] is the processing method for a SiC substrate according to any one of Methods [2] to [22], wherein the annealing step comprises a heating step of heating the crucible, and the heating step includes introducing an inert gas into the inside of the crucible and maintaining a pressure inside the crucible at 5 kPa or more.

Method [25] is the processing method for a SiC substrate according to any one of Methods [2] to [22], wherein the annealing step comprises a heating step of heating the crucible, and the heating step includes introducing an inert gas into the inside of the crucible and maintaining a pressure inside the crucible at 10 kPa or more.

Method [26] is the processing method for a SiC substrate according to any one of Methods [2] to [25], wherein the annealing step comprises a heating step of heating the crucible, and the heating step includes heating the crucible and maintaining a temperature inside the crucible at 1800°C or more.

Method [27] is the processing method for a SiC substrate according to any one of Methods [2] to [25], wherein the annealing step comprises a heating step of heating the crucible, and the heating step includes heating the crucible and maintaining a temperature inside the crucible at 2000°C or more.

Method [28] is the processing method for a SiC substrate according to any one of Methods [2] to [25], wherein the annealing step comprises a heating step of heating the crucible, and the heating step includes heating the crucible and maintaining a temperature inside the crucible at 2200°C or more.

Method [29] is the processing method for a SiC substrate according to any one of Methods [2] to [28], wherein the annealing step comprises a heating step of heating the crucible, and the heating step includes introducing an inert gas into the inside of the crucible and maintaining a pressure inside the crucible at 1 kPa or more, and heating the crucible and maintaining a temperature inside the crucible at 1800°C or more.

Method [30] is the processing method for a SiC substrate according to any one of Methods [2] to [28], wherein the annealing step comprises a heating step of heating the crucible, and the heating step includes introducing an inert gas into the inside of the crucible and maintaining a pressure inside the crucible at 5 kPa or more, and heating the crucible and maintaining a temperature inside the crucible at 2000°C or more.

Method [31] is the processing method for a SiC substrate according to any one of Methods [2] to [28], wherein the annealing step comprises a heating step of heating the crucible, and the heating step includes introducing an inert gas into the inside of the crucible and maintaining a pressure inside the crucible at 5 kPa or more, and heating the crucible and maintaining a temperature inside the crucible at 2200°C or more.

Method [32] is the processing method for a SiC substrate according to any one of Methods [2] to [28], wherein the annealing step comprises a heating step of heating the crucible, and the heating step includes introducing an inert gas into the inside of the crucible and maintaining a pressure inside the crucible at 10 kPa or more, and heating the crucible and maintaining a temperature inside the crucible at 2200°C or more.

Method [33] is the processing method for a SiC substrate according to any one of Methods [2] to [32], wherein the annealing step comprises a heating step of heating the crucible, and the heating step includes forming a temperature gradient inside the crucible in a direction penetrating the SiC substrate.

Method [34] is the processing method for a SiC substrate according to Method [33], wherein the heating step includes forming the temperature gradient in a sense such that the temperature decreases from the C face side toward the Si face side of the SiC substrate.

Method [35] is the processing method for a SiC substrate according to any one of Methods [1] to [34], wherein in the annealing step, a protective film is not formed on the surface of the SiC substrate.

Method [36] is the processing method for a SiC substrate according to any one of Methods [1] to [35], wherein the etching step includes heating the SiC substrate inside a crucible made of SiC, and in the etching step, the inside of the crucible is maintained in an environment including a gas composed of one or both of Si element and C element.

Method [37] is the processing method for a SiC substrate according to Method [36], wherein in the etching step, the inside of the crucible is maintained in a SiC-C equilibrium vapor pressure environment.

Method [38] is the processing method for a SiC substrate according to Method [37], wherein in the etching step, a temperature inside the crucible is 1600°C or more and 2000°C or less.

Method [39] is the processing method for a SiC substrate according to Method [38], wherein in the etching step, the temperature inside the crucible is lower than a temperature inside the crucible in the annealing step.

Method [40] is the processing method for a SiC substrate according to Method [36], wherein in the etching step, the inside of the crucible is maintained in a SiC-Si equilibrium vapor pressure environment.

Method [41] is the processing method for a SiC substrate according to Method [40], wherein in the etching step, a temperature inside the crucible is 1800°C or more and 2000°C or less.

Method [42] is the processing method for a SiC substrate according to Method [41], wherein in the etching step, the temperature inside the crucible is lower than a temperature inside the crucible in the annealing step.

Method [43] is the processing method for a SiC substrate according to any one of Methods [36] to [42], wherein in the etching step, a temperature gradient is formed inside the crucible in a direction penetrating the SiC substrate and in a sense such that the temperature decreases from a C face side toward a Si face side of the SiC substrate.

Method [44] is the processing method for a SiC substrate according to any one of Methods [36] to [39] or [43], wherein the etching step has an etching accommodating step of accommodating the SiC substrate inside the crucible and an etching heating step of heating the crucible, and the etching heating step includes maintaining the inside of the crucible in a SiC-C equilibrium vapor pressure environment.

Method [45] is the processing method for a SiC substrate according to Method [44], wherein the etching heating step includes heating the crucible to generate a gas composed of one or both of Si element and C element from the crucible into the inside of the crucible, thereby maintaining the inside of the crucible in a SiC-C equilibrium vapor pressure environment.

Method [46] is the processing method for a SiC substrate according to Method [44] or [45], wherein the etching heating step includes heating the crucible and maintaining a temperature inside the crucible at 1600°C or more and 2000°C or less.

Method [47] is the processing method for a SiC substrate according to Method [46], wherein the etching heating step includes heating the crucible and maintaining the temperature inside the crucible lower than a temperature inside the crucible in the annealing step.

Method [48] is the processing method for a SiC substrate according to any one of Methods [36] or [40] to [43], wherein the etching step has an etching accommodating step of accommodating the SiC substrate inside the crucible and an etching heating step of heating the crucible, and the etching heating step includes maintaining the inside of the crucible in a SiC-Si equilibrium vapor pressure environment.

Method [49] is the processing method for a SiC substrate according to Method [48], wherein the etching accommodating step includes accommodating a Si gas source together with the SiC substrate inside the crucible, and the etching heating step includes heating the crucible together with the Si gas source to generate a gas composed of one or both of Si element and C element from the crucible into the inside of the crucible and to generate Si gas from the Si gas source into the inside of the crucible, thereby maintaining the inside of the crucible in a SiC-Si equilibrium vapor pressure environment.

Method [50] is the processing method for a SiC substrate according to Method [48] or [49], wherein the etching heating step includes heating the crucible and maintaining a temperature inside the crucible at 1800°C or more and 2000°C or less.

Method [51] is the processing method for a SiC substrate according to Method [50], wherein the etching heating step includes heating the crucible and maintaining the temperature inside the crucible lower than a temperature inside the crucible in the annealing step.

Method [52] is the processing method for a SiC substrate according to any one of Methods [36] to [51], wherein the etching step has an etching heating step of heating the crucible, and the etching heating step includes forming a temperature gradient inside the crucible in a direction penetrating the SiC substrate and in a sense such that the temperature decreases from a C face side toward a Si face side of the SiC substrate.

Method [53] is the processing method for a SiC substrate according to any one of Methods [36] to [52], not comprising a step of performing mechanical processing on the SiC substrate after the etching step.

Method [54] is the processing method for a SiC substrate according to any one of Methods [36] to [53], wherein the etching step is performed at least twice, a first etching step and a second etching step, the first etching step includes etching the SiC substrate that has undergone the annealing step, the second etching step includes etching the SiC substrate that has undergone the first etching step, in the first etching step, the inside of the crucible is maintained in a SiC-C equilibrium vapor pressure environment, and in the second etching step, the inside of the crucible is maintained in a SiC-Si equilibrium vapor pressure environment.

Method [55] is the processing method for a SiC substrate according to Method [54], wherein in the first etching step, a temperature inside the crucible is 1600°C or more and 2000°C or less, and in the second etching step, a temperature inside the crucible is 1800°C or more and 2000°C or less.

Method [56] is the processing method for a SiC substrate according to Method [55], wherein in the first etching step, the temperature inside the crucible is lower than a temperature inside the crucible in the annealing step, and in the second etching step, the temperature inside the crucible is lower than the temperature inside the crucible in the annealing step and higher than a temperature inside the crucible in the first etching step.

Method [57] is the processing method for a SiC substrate according to any one of Methods [54] to [56], wherein in the first etching step, a temperature gradient is formed inside the crucible in a direction penetrating the SiC substrate and in a sense such that the temperature decreases from a C face side toward a Si face side of the SiC substrate, and in the second etching step, a temperature gradient is formed inside the crucible in a direction penetrating the SiC substrate and in a sense such that the temperature decreases from a C face side toward a Si face side of the SiC substrate.

Method [58] is the processing method for a SiC substrate according to any one of Methods [54] to [57], not comprising a step of performing mechanical processing on the SiC substrate after the second etching step.

Method [59] is the processing method for a SiC substrate according to any one of Methods [1] to [58], comprising a growth step of growing the SiC substrate that has undergone the etching step in an environment including a gas composed of one or both of Si element and C element.

Method [60] is the processing method for a SiC substrate according to Method [59], wherein the growth step includes heating the SiC substrate inside a crucible made of SiC, and in the growth step, the inside of the crucible is maintained in an environment including a gas composed of one or both of Si element and C element.

Method [61] is the processing method for a SiC substrate according to Method [60], wherein in the growth step, the inside of the crucible is maintained in a SiC-C equilibrium vapor pressure environment.

Method [62] is the processing method for a SiC substrate according to Method [61], wherein in the growth step, a temperature inside the crucible is 1600°C or more and 2000°C or less.

Method [63] is the processing method for a SiC substrate according to Method [62], wherein in the growth step, the temperature inside the crucible is lower than a temperature inside the crucible in the annealing step.

Method [64] is the processing method for a SiC substrate according to Method [60], wherein in the growth step, the inside of the crucible is maintained in a SiC-Si equilibrium vapor pressure environment.

Method [65] is the processing method for a SiC substrate according to Method [64], wherein in the growth step, a temperature inside the crucible is 1800°C or more and 2000°C or less.

Method [66] is the processing method for a SiC substrate according to Method [65], wherein in the growth step, the temperature inside the crucible is lower than a temperature inside the crucible in the annealing step.

Method [67] is the processing method for a SiC substrate according to any one of Methods [60] to [66], wherein in the growth step, a temperature gradient is formed inside the crucible in a direction penetrating the SiC substrate and in a sense such that the temperature decreases from a Si face side toward a C face side of the SiC substrate.

Method [68] is the processing method for a SiC substrate according to any one of Methods [60] to [63] or [67], wherein the growth step has a growth accommodating step of accommodating the SiC substrate inside the crucible and a growth heating step of heating the crucible, and the growth heating step includes maintaining the inside of the crucible in a SiC-C equilibrium vapor pressure environment.

Method [69] is the processing method for a SiC substrate according to Method [68], wherein the growth heating step includes heating the crucible to generate a gas composed of one or both of Si element and C element from the crucible into the inside of the crucible, thereby maintaining the inside of the crucible in a SiC-C equilibrium vapor pressure environment.

Method [70] is the processing method for a SiC substrate according to Method [68] or [69], wherein the growth heating step includes heating the crucible and maintaining a temperature inside the crucible at 1600°C or more and 2000°C or less.

Method [71] is the processing method for a SiC substrate according to Method [70], wherein the growth heating step includes heating the crucible and maintaining the temperature inside the crucible lower than a temperature inside the crucible in the annealing step.

Method [72] is the processing method for a SiC substrate according to any one of Methods [60] or [64] to [67], wherein the growth step has a growth accommodating step of accommodating the SiC substrate inside the crucible and a growth heating step of heating the crucible, and the growth heating step includes maintaining the inside of the crucible in a SiC-Si equilibrium vapor pressure environment.

Method [73] is the processing method for a SiC substrate according to Method [72], wherein the growth accommodating step includes accommodating a Si gas source together with the SiC substrate inside the crucible, and the growth heating step includes heating the crucible together with the Si gas source to generate a gas composed of one or both of Si element and C element from the crucible into the inside of the crucible and to generate Si gas from the Si gas source into the inside of the crucible, thereby maintaining the inside of the crucible in a SiC-Si equilibrium vapor pressure environment.

Method [74] is the processing method for a SiC substrate according to Method [72] or [73], wherein the growth heating step includes heating the crucible and maintaining a temperature inside the crucible at 1800°C or more and 2000°C or less.

Method [75] is the processing method for a SiC substrate according to Method [74], wherein the growth heating step includes heating the crucible and maintaining the temperature inside the crucible lower than a temperature inside the crucible in the annealing step.

Method [76] is the processing method for a SiC substrate according to any one of Methods [60] to [75], wherein the growth step has a growth heating step of heating the crucible, and the growth heating step includes forming a temperature gradient inside the crucible in a direction penetrating the SiC substrate and in a sense such that the temperature decreases from a Si face side toward a C face side of the SiC substrate.

Method [77] is the processing method for a SiC substrate according to any one of Methods [60] to [76], not comprising a step of performing mechanical processing on the SiC substrate after the growth step.

Method [78] is the processing method for a SiC substrate according to any one of Methods [60] to [77], wherein the growth step is performed at least twice, a first growth step and a second growth step, the first growth step includes growing the SiC substrate that has undergone the etching step, the second growth step includes growing the SiC substrate that has undergone the first growth step, in the first growth step, the inside of the crucible is maintained in a SiC-C equilibrium vapor pressure environment, and in the second growth step, the inside of the crucible is maintained in a SiC-Si equilibrium vapor pressure environment.

Method [79] is the processing method for a SiC substrate according to Method [78], wherein in the first growth step, a temperature inside the crucible is 1600°C or more and 2000°C or less, and in the second growth step, a temperature inside the crucible is 1800°C or more and 2000°C or less.

Method [80] is the processing method for a SiC substrate according to Method [79], wherein in the first growth step, the temperature inside the crucible is lower than a temperature inside the crucible in the annealing step, and in the second growth step, the temperature inside the crucible is lower than the temperature inside the crucible in the annealing step and higher than the temperature inside the crucible in the first growth step.

Method [81] is the processing method for a SiC substrate according to any one of Methods [78] to [80], wherein in the first growth step, a temperature gradient is formed inside the crucible in a direction penetrating the SiC substrate and in a sense such that the temperature decreases from a Si face side toward a C face side of the SiC substrate, and in the second growth step, a temperature gradient is formed inside the crucible in a direction penetrating the SiC substrate and in a sense such that the temperature decreases from a Si face side toward a C face side of the SiC substrate.

Method [82] is the processing method for a SiC substrate according to any one of Methods [78] to [81], not comprising a step of performing mechanical processing on the SiC substrate after the second etching step.

Further, one of the embodiments of the present invention for achieving the above object is a method for removing a subsurface damaged layer of a SiC substrate, which is the following methods [83] to [85].

Method [83] is a method for removing a subsurface damaged layer of a SiC substrate, comprising performing any one of Methods [1] to [82] on a SiC substrate having a subsurface damaged layer to remove the subsurface damaged layer.

Method [84] is the method for removing a subsurface damaged layer of a SiC substrate according to Method [83], comprising performing any one of Methods [1] to [82] on the SiC substrate on which the subsurface damaged layer has been formed by mechanical processing.

Method [85] is the method for removing a subsurface damaged layer of a SiC substrate according to Method [83] or [84], wherein the annealing step includes exchanging atoms between a surface layer of the SiC substrate and the inert gas environment to remove the subsurface damaged layer.

Further, one of the embodiments of the present invention for achieving the above object is a method for reducing surface roughness of a SiC substrate, which is the following methods [86] to [88].

Method [86] is a method for reducing surface roughness of a SiC substrate, comprising performing any one of Methods [1] to [82] on a SiC substrate having an Si face with an arithmetic mean roughness Ra of 15 nm or more to reduce the arithmetic mean roughness Ra.

Method [87] is the method for reducing surface roughness of a SiC substrate according to Method [86], comprising performing any one of Methods [1] to [82] on the SiC substrate that has undergone mechanical processing.

Method [88] is the method for reducing surface roughness of a SiC substrate according to Method [86] or [87], wherein the annealing step includes exchanging atoms between a surface layer of the SiC substrate and the inert gas environment to level the surface layer.

### Advantageous Effects of Invention

According to the present invention, a novel processing method for a SiC substrate can be provided. More specifically, a non-contact processing method capable of substituting the initial stage of conventional processing of a SiC substrate can be provided. Furthermore, a processing method capable of reducing material loss generated in the initial stage of this processing can be provided.

### Brief Description of Drawings

Fig. 1 is an explanatory diagram of a concept of a processing method according to an embodiment of the present invention.
Fig. 2 is an explanatory diagram of a concept of a processing method according to an embodiment of the present invention.
Fig. 3 is an explanatory diagram of a concept of a processing method according to an embodiment of the present invention.
Fig. 4 is an explanatory diagram of a concept of a processing method according to an embodiment of the present invention.
Fig. 5 is an explanatory diagram of a concept of a processing method according to an embodiment of the present invention.
Fig. 6 is an explanatory diagram of a first preferred mode of the embodiment of the present invention.
Fig. 7 is an explanatory diagram of a modification of the first preferred mode of the embodiment of the present invention.
Fig. 8 is an explanatory diagram of the first preferred mode of the embodiment of the present invention.
Fig. 9 is an explanatory diagram of a second preferred mode of the embodiment of the present invention.
Fig. 10 is an explanatory diagram of the second preferred mode of the embodiment of the present invention.
Fig. 11 is an explanatory diagram of a third preferred mode of the embodiment of the present invention.
Fig. 12 is an explanatory diagram of a fourth preferred mode of the embodiment of the present invention.
Fig. 13 is an explanatory diagram of a fifth preferred mode of the embodiment of the present invention.
Fig. 14 is an explanatory diagram of results of an example of the present invention.
Fig. 15 is an explanatory diagram of results of an example of the present invention.
Fig. 16 is an explanatory diagram of results of an example of the present invention.
Fig. 17 is an explanatory diagram of results of an example of the present invention.

### Description of Embodiments

One of the embodiments of the present invention is a processing method for a SiC substrate. This processing method comprises an annealing step of heating a SiC substrate inside a crucible made of SiC.

In the annealing step of this processing method, the inside of the crucible is maintained in an inert gas environment. The term "inert gas environment" refers to an environment containing an inert gas. Examples of the inert gas include Ar gas and N2 gas. The inert gas environment of this processing method includes Ar gas as an inert gas. Here, it is preferable that the majority of the inert gas is Ar gas, and it is also preferable that substantially the whole of the inert gas is Ar gas. Note that a part of the inert gas may be N2 gas. That is, the annealing step of this processing method can be said to be a step of annealing the SiC substrate under an inert gas environment.

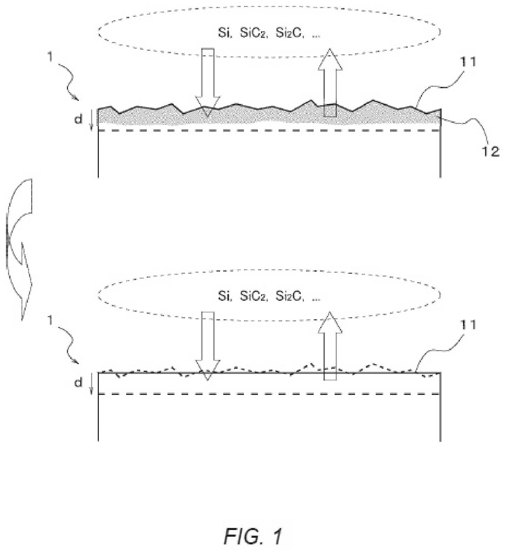

Hereinafter, the concept of this processing method will be described in detail with reference to Figs. 1 to 5. Figs. 1 to 5 show a SiC substrate 1, a surface 11 (Si face 111 and C face 112) of the SiC substrate, a subsurface damaged layer 12 included in the SiC substrate, a crucible 2 made of SiC, and a base body 21 and a lid 22 of the crucible 2. The term "subsurface damaged layer" refers to a layer that contains damage due to mechanical processing and has a high possibility of exerting an adverse effect on the performance of a SiC semiconductor device. An example of the subsurface damaged layer includes a surface layer that has undergone mechanical processing on the side of the Si face 111 where a device will be formed in the future. The term "mechanical processing" refers to processing that physically destroys the atomic arrangement of the substrate. Examples of mechanical processing include ingot slicing (for example, multi-wire saw cutting, laser cutting, electric discharge cutting), lapping and/or grinding, and polishing (for example, mechanical polishing, chemical mechanical polishing).

By heating the SiC substrate 1, as an example, reactions represented by Chems. 1 to 3 occur. That is, by heating the SiC substrate 1, sublimation of source gas from the SiC substrate 1 and recrystallization of source gas onto the SiC substrate 1 occur. The term "source gas" refers to a gas composed of one or both of Si element and C element. Examples of the source gas include Si gas, SiC2 gas, Si2C gas, and a mixed gas thereof.

[Chem. 1] SiC(s) → Si(v) + C(s)

[Chem. 2] **2C(s) + Si(v)** → SiC₂(v) **C(s) + 2Si(v)** → **Si₂C(v)**

[Chem. 3] SiC₂(v) + Si(v) → 2SiC(s) Si2C(v) → SiC(s)+ Si(v)

The reaction of Chem. 1 corresponds to a thermal decomposition reaction. In the thermal decomposition reaction, Si gas desorbs from the SiC substrate 1, and C remains in the SiC substrate 1. When the thermal decomposition reaction is dominant, the SiC substrate 1 is carbonized.

The reaction of Chem. 2 corresponds to a sublimation reaction. In the sublimation reaction, C of the SiC substrate 1 sublimates as a source gas. When the sublimation reaction is dominant, the SiC substrate 1 is etched.

The reaction of Chem. 3 corresponds to a recrystallization reaction. In the recrystallization reaction, the source gas recrystallizes on the SiC substrate 1. When the recrystallization reaction is dominant, the SiC substrate 1 grows.

This processing method is based on the idea of vigorously exchanging atoms between the surface layer of the SiC substrate 1 and the annealing environment by strongly promoting both the sublimation reaction and the recrystallization reaction, that is, strongly promoting metabolism of atoms constituting the surface layer of the SiC substrate 1. The term "surface layer" refers to a layer in a range from the surface to a predetermined depth.

As shown in Fig. 1, this processing method includes causing metabolism of atoms constituting the surface layer in a range from the surface 11 to a depth d. The depth d depends on the vigorousness of the sublimation reaction and the recrystallization reaction. Thereby, the subsurface damaged layer 12 included in the range from the surface 11 to the depth d can be removed in a short time. Further, by the surface layer of the SiC substrate 1 being leveled in the process of metabolism, a SiC substrate 1 having small surface roughness is realized. That is, this processing method can be used both as a method for removing the subsurface damaged layer 12 of the SiC substrate 1 and as a method for reducing the roughness of the surface 11 of the SiC substrate 1.

When the sublimation reaction is more dominant than the recrystallization reaction, atoms constituting the surface layer of the SiC substrate 1 macroscopically decrease, and the surface 11 is etched. Here, in the etching in this processing method, a macroscopic decrease of atoms occurs because a balance between microscopic decrease and increase of atoms shifts toward the decrease. In comparison with this, in conventional etching, a macroscopic decrease of atoms occurs by repeated microscopic decrease of atoms.

When the recrystallization reaction is more dominant than the sublimation reaction, atoms constituting the surface layer of the SiC substrate 1 macroscopically increase, and the surface 11 grows. Here, in the growth in this processing method, a macroscopic increase of atoms occurs because a balance between microscopic decrease and increase of atoms shifts toward the increase. In comparison with this, in conventional growth, a macroscopic increase of atoms occurs by repeated microscopic increase of atoms.

In the etching and growth in this processing method, the subsurface damaged layer 12 included in the range from the surface 11 to the depth d can always be removed. Thus, in the etching of this processing method, the subsurface damaged layer 12 can be removed in a range wider than an etching range. Further, in the growth of this processing method, a growth layer from which the influence of the subsurface damaged layer 12 is eliminated can be formed in a single step. In comparison with this, in conventional etching, a subsurface damaged layer not included in the etching range cannot be removed, and in conventional growth, any subsurface damaged layer cannot be removed at all. That is, in order to eliminate an adverse effect on a device due to the subsurface damaged layer by the conventional method, it is necessary to etch the entire surface layer in a range including the subsurface damaged layer and thereafter form a growth layer.

This processing method includes controlling etching and growth of the surface 11 by controlling a macroscopic flow of the source gas. Examples of means for controlling the macroscopic flow of the source gas include controlling a temperature gradient and controlling a source gas concentration gradient.

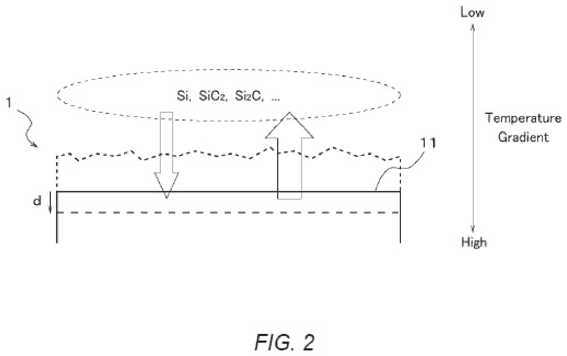

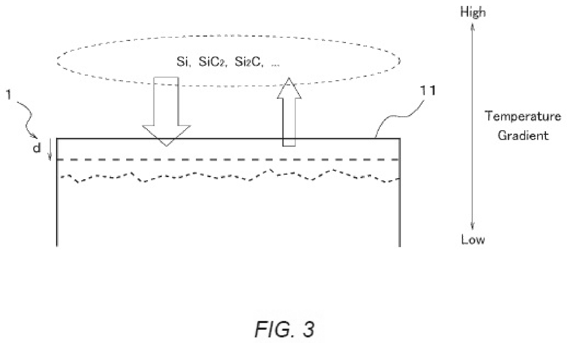

As shown in Fig. 2, when the temperature gradient is formed such that the temperature decreases as the distance from the surface 11 increases, the macroscopic flow of the source gas becomes a sense away from the surface 11. At this time, the sublimation reaction becomes more dominant than the recrystallization reaction, and the surface 11 is etched. On the other hand, as shown in Fig. 3, when the temperature gradient is formed such that the temperature decreases as the distance to the surface 11 decreases, the macroscopic flow of the source gas becomes a sense approaching the surface 11. At this time, the recrystallization reaction becomes more dominant than the sublimation reaction, and the surface 11 grows.

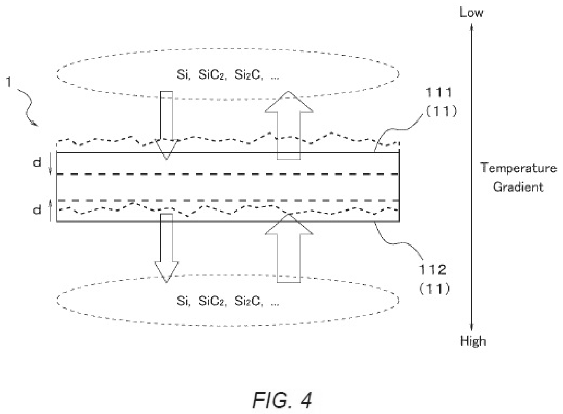

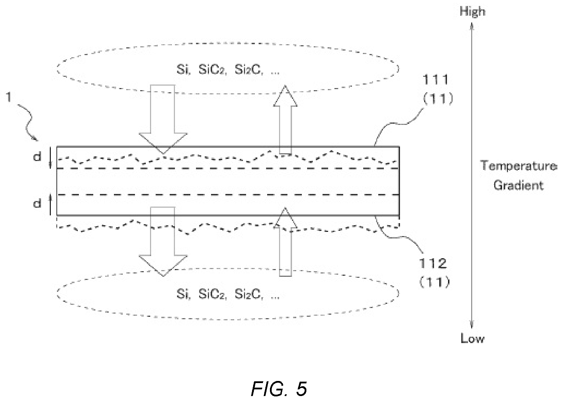

This processing method includes causing metabolism of atoms constituting the surface layer of the SiC substrate 1 on both the Si face 111 and the C face 112, that is, simultaneously processing both the Si face 111 and the C face 112. As shown in Fig. 4, when the temperature gradient is formed in a sense such that the temperature decreases from the C face 112 side toward the Si face 111 side, the macroscopic flow of the source gas becomes a sense away from the Si face 111 and a sense approaching the C face 112. At this time, the Si face 111 is etched, and at the same time, the C face 112 grows. On the other hand, as shown in Fig. 5, when the temperature gradient is formed in a sense such that the temperature decreases from the Si face 111 side toward the C face 112 side, the macroscopic flow of the source gas becomes a sense approaching the Si face 111 and a sense away from the C face 112. At this time, the Si face 111 grows, and at the same time, the C face 112 is etched.

This processing method includes simultaneously processing both the Si face 111 and the C face 112 while maintaining the substrate thickness of the SiC substrate 1. An etching rate or a growth rate on the surface 11 generally depends on the temperature gradient in the vicinity of the surface 11. Here, although the temperature gradient itself changes with time, since the Si face 111 and the C face 112 are spatially very close (for example, about 400 µm), the temperature gradients at the Si face 111 and the C face 112 are always substantially the same. As a result, the etching rate on one surface 11 and the growth rate on the other surface 11 always become substantially the same. That is, regardless of the magnitude and the sense of the temperature gradient and its temporal change, the etching amount on one surface 11 and the growth amount on the other surface 11 become substantially the same, and the substrate thickness of the SiC substrate 1 is maintained. Thereby, material loss associated with the processing of the SiC substrate 1 can be made substantially zero within the substrate.

### <Processing Method X>

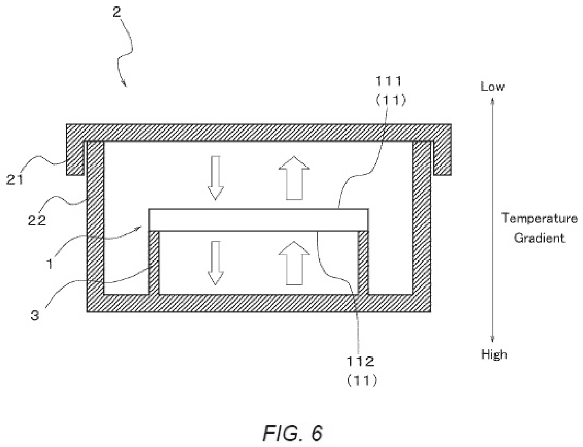

The first preferred mode of this processing method will be described in detail with reference to Figs. 6 to 8. In Figs. 6 to 8, configurations similar to the configurations shown in Figs. 1 to 5 are denoted by the same reference signs. Hereinafter, the first preferred mode of this processing method is referred to as Processing Method X.

### <Preparation Step S1>

Processing Method X comprises a preparation step S1 of preparing a SiC substrate 1. Note that the preparation step S1 may include preparing a plurality of SiC substrates 1.

The preparation step S1 may include preparing a substrate having a subsurface damaged layer as the SiC substrate 1. This substrate may be a substrate (for example, an As-sliced substrate) on which a subsurface damaged layer has been formed through mechanical processing (for example, ingot slicing, lapping and/or grinding, mechanical polishing, chemical mechanical polishing). That is, Processing Method X can be used as a method for removing the subsurface damaged layer 12 of the SiC substrate 1.

The preparation step S1 may include preparing a substrate having a Si face with an arithmetic mean roughness Ra of 15 nm or more (or more than 15 nm) as the SiC substrate 1. This arithmetic mean roughness Ra may be 30 nm or more (or more than 30 nm), or may be 100 nm or more (or more than 100 nm). Although there is no particular upper limit to this arithmetic mean roughness Ra, it is preferably 500 nm or less (or less than 500 nm). Note that the "arithmetic mean roughness Ra" is determined as an average value of absolute differences between a profile line and a mean line thereof in an AFM image (10 µm × 10 µm) of the surface of the substrate (excluding, however, an edge portion). This SiC substrate may be a SiC substrate that has undergone mechanical processing (for example, ingot slicing, lapping and/or grinding). That is, Processing Method X can be used as a method for reducing the roughness of the surface 11 of the SiC substrate 1.

The preparation step S1 includes preparing a substrate on which a protective film is not formed on the surface as the SiC substrate 1. Thereby, both surfaces of the Si face 111 and the C face 112 can be processed simultaneously.

### <Annealing Step S2>

As shown in Fig. 6, Processing Method X comprises an annealing step S2 of heating the SiC substrate 1 inside the crucible 2.

The inner wall of the crucible 2 is made of SiC (for example, polycrystalline SiC, single crystal SiC). It is also preferable that substantially the whole of the crucible 2 is made of SiC. It is preferable that this SiC is polycrystalline SiC.

The crucible 2 comprises a base body 21 having an opening and a lid 22. The inside of the crucible 2 is formed by covering the opening of the base body 21 with the lid 22. The SiC substrate 1 is arranged inside the crucible 2 in a state where the opening of the base body 21 faces upward and the lid 22 is placed on the base body 21 to cover the opening of the base body 21.

The SiC substrate 1 is supported by a substrate support 3. The substrate support 3 is integrally formed with the base body 21 or the lid 22. Here, the substrate support 3 may be provided from the inner wall of the base body 21 or may be provided from the inner wall of the lid 22. Note that the substrate support 3 may be formed separately from the base body 21 or the lid 22. Here, it is preferable that the substrate support 3 is placed on the inner bottom of the base body 21.

It is preferable that the substrate support 3 is made of SiC (for example, polycrystalline SiC, single crystal SiC).

The SiC substrate 1 is supported by the substrate support 3 from below the C face 112 in a state where the Si face 111 faces upward and the C face 112 faces downward. Note that the SiC substrate 1 may be supported by the substrate support 3 from below the Si face 111 in a state where the Si face 111 faces downward and the C face 112 faces upward.

The SiC substrate 1 is supported by the substrate support 3 via a slight contact area, and as a result, is supported in midair inside the crucible 2. The SiC substrate 1 may be supported at three or more points, or may be supported by a line such as a circle. It is preferable that the SiC substrate 1 is arranged inside the crucible 2 such that one surface 11 directly faces the inner wall of the crucible 2 and the other surface 11 directly faces the inner wall of the crucible 2 by being supported in midair inside the crucible 2. The term "directly face" refers to two members facing each other without being blocked by other members. It is preferable that the SiC substrate 1 is supported in midair and arranged in the approximate center of the inside of the crucible 2.

The inside of the crucible 2 is maintained in an inert gas environment. The pressure inside the crucible 2 is 1 kPa or more (or more than 1 kPa). This pressure may be 5 kPa or more (or more than 5 kPa), may be 10 kPa or more (or more than 10 kPa), or may be 100 kPa or more (or more than 100 kPa). Although there is no particular upper limit to this pressure, it is preferably 300 kPa or less (or less than 300 kPa). The temperature inside the crucible 2 is 1800°C or more (or more than 1800°C). This temperature is preferably 1900°C or more (or more than 1900°C), preferably 2000°C or more (or more than 2000°C), preferably 2100°C or more (or more than 2100°C), and preferably 2200°C or more (or more than 2200°C). Although there is no particular upper limit to this temperature, it is preferably 2300°C or less (or less than 2300°C). A preferred combination of the pressure and the temperature inside the crucible 2 is a combination of 1 kPa or more (or more than 1 kPa) and 1800°C or more (or more than 1800°C). This combination is preferably a combination of 1 kPa or more (or more than 1 kPa) and 1900°C or more (or more than 1900°C), and preferably a combination of 1 kPa or more (or more than 1 kPa) and 2000°C or more (or more than 2000°C). This combination is preferably a combination of 10 kPa or more (or more than 10 kPa) and 1800°C or more (or more than 1800°C), preferably a combination of 10 kPa or more (or more than 10 kPa) and 1900°C or more (or more than 1900°C), and preferably a combination of 10 kPa or more (or more than 10 kPa) and 2000°C or more (or more than 2000°C).

A particularly preferred combination of the pressure and the temperature inside the crucible 2 is a combination of 5 kPa or more (or more than 5 kPa) and 2000°C or more (or more than 2000°C). This combination is preferably a combination of 5 kPa or more (or more than 5 kPa) and 2200°C or more (or more than 2200°C), preferably a combination of 10 kPa or more (or more than 10 kPa) and 2000°C or more (or more than 2000°C), and preferably a combination of 10 kPa or more (or more than 10 kPa) and 2200°C or more (or more than 2200°C).

A temperature gradient is formed inside the crucible 2. Further, a temperature difference is formed between the base body 21 and the lid 22. There is no particular limitation on the magnitude of this temperature gradient. This temperature gradient is formed in a direction penetrating the SiC substrate 1. This temperature gradient is formed in a sense such that the temperature decreases from the C face 112 side toward the Si face 111 side. Note that this temperature gradient may be formed in a sense such that the temperature decreases from the Si face 111 toward the C face 112.

In Processing Method X, by annealing the SiC substrate 1 inside the crucible 2, the Si face 111 can be etched and, at the same time, the C face 112 can be grown while maintaining the substrate thickness of the SiC substrate 1. As a result, the subsurface damaged layer 12 included in the surface layer on the Si face 111 side can be sufficiently removed, and the roughness of both surfaces of the Si face 111 and the C face 112 can be reduced. Note that if the temperature gradient is reversed, the Si face 111 can be grown and, at the same time, the C face 112 can be etched while maintaining the substrate thickness of the SiC substrate 1. As a result, a growth layer can be formed on the Si face 111 at the same time as removing the subsurface damaged layer 12 included in the surface layer on the Si face 111 side.

In Processing Method X, since the SiC substrate 1 is supported inside the crucible 2 in the form described above, etching or growth of the surface 11 can be performed under suitable conditions.

Since the crucible 2 and the substrate support 3 are made of SiC, a source gas is generated from the crucible 2 and the substrate support 3 into the inside of the crucible 2, and a state where sufficient source gas exists inside the crucible 2 is maintained. As a result, both the sublimation reaction and the recrystallization reaction can be strongly promoted. Here, also in the crucible 2, similarly to the SiC substrate 1, carbonization of the crucible 2 can be suppressed by strongly promoting both the sublimation reaction and the recrystallization reaction. Further, gas that has not recrystallized on the SiC substrate 1 can be recrystallized and recovered on the crucible 2 and the substrate support 3, and as a result, material loss can be made substantially zero in the crucible 2 and the entire inside of the crucible 2. In addition, since the crucible 2 is made of polycrystalline SiC, the source gas generated from a unit area of the crucible 2 becomes larger than the source gas generated from a unit area of the SiC substrate 1 which is single crystal SiC, so that the etching amount of the Si face 111 becomes slightly smaller and the growth amount of the C face 112 becomes slightly larger. As a result, the substrate thickness of the SiC substrate 1 can be slightly increased before and after heating.

Since the inside of the crucible 2 is formed by placing the lid 22 on the base body 21, gas (for example, inert gas) can go back and forth between the inside and outside of the crucible 2 through a slight gap between the base body 21 and the lid 22 as a path, while the inside of the crucible 2 is a closed environment. That is, the gas inside the crucible 2 can be adjusted without opening the crucible 2.

Since the SiC substrate 1 is supported by the substrate support 3 as described above, a macroscopic flow of the source gas from the inner wall of the crucible 2 to the C face 112 and a macroscopic flow of the source gas from the Si face 111 to the inner wall of the crucible 2 are formed. Thereby, an annealing environment in which a balance is maintained in the crucible 2 and the entire inside of the crucible 2, in which the SiC substrate 1 and the inner wall of the crucible 2 steadily exchange the source gas via the inert gas environment, can be formed. Further, since the macroscopic flow of the source gas from the inner wall of the crucible 2 to the C face and the macroscopic flow of the source gas from the Si face 111 to the inner wall of the crucible 2 are substantially the same, the etching amount on the Si face 111 and the growth amount on the C face 112 can be made substantially the same, and the substrate thickness of the SiC substrate 1 can be made substantially the same before and after heating.

In Processing Method X, since the inside of the crucible 2 is maintained in an inert gas environment in the form described above, etching or growth of the surface 11 can be performed under suitable conditions.

Since the inside of the crucible 2 is maintained in the inert gas environment as described above, diffusion of the source gas sublimated from the SiC substrate 1 is suppressed, the source gas concentration in the vicinity of the SiC substrate 1 increases, and thermal motion of the source gas becomes vigorous. As a result, both the sublimation reaction and the recrystallization reaction are strongly promoted on the surface 11 of the SiC substrate 1.

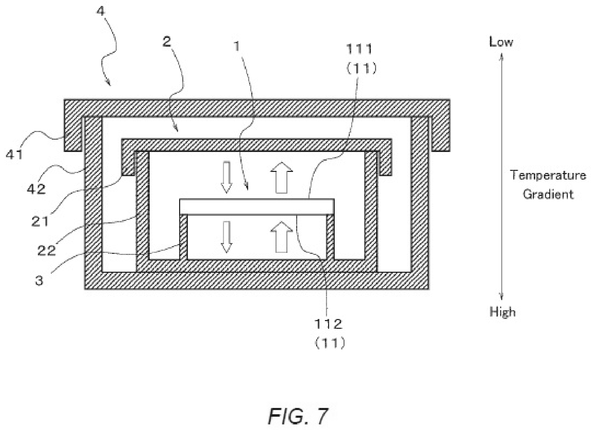

Note that, as shown in Fig. 7, the crucible 2 may be arranged inside a large crucible 4.

The inner wall of the large crucible 4 is configured to include a C element occluding material. The term "C element occluding material" refers to a material that occludes C element during heating. Examples of the C element occluding material include Ta and TaC. It is also preferable that substantially the whole of the large crucible 4 is configured to include the C element occluding material.

It is preferable that the inner wall of the large crucible 4 is configured to include a Si gas generating material. The term "Si gas generating material" refers to a material that generates Si gas during heating. Examples of the Si gas generating material include Si and tantalum silicide. Substantially the whole of the large crucible 4 may be configured to include the Si gas generating material.

A Si gas source may be arranged inside the large crucible 4 and outside the crucible 2. The term "Si gas source" refers to a member that generates Si gas during heating. An example of the Si gas source includes Si (for example, a Si piece).

The large crucible 4 comprises a large base body 41 having an opening and a large lid 42. The inside of the large crucible 4 is formed by covering the opening of the large base body 41 with the large lid 42. The crucible 2 is arranged inside the large crucible 4 in a state where the opening of the large base body 41 faces upward and the large lid 42 is placed on the large base body 41 to cover the opening of the large base body 41.

In Processing Method X, since the crucible 2 is arranged inside the large crucible 4 in the form described above, etching or growth of the surface 11 can be performed under suitable conditions.

Since the inner wall of the large crucible 4 is configured to include the C element occluding material, C element is removed from the source gas generated from the crucible 2, and the outside of the crucible 2 becomes an environment where Si element is dominant. As a result, carbonization of the crucible 2 can be suppressed.

Since the inner wall of the large crucible 4 is configured to include the Si gas generating material or the Si gas source is arranged inside the large crucible 4 and outside the crucible 2, the outside of the crucible 2 becomes an environment where Si element is dominant. As a result, carbonization of the crucible 2 can be suppressed.

Hereinafter, steps included in the annealing step S2 will be described in detail.

### <Accommodating Step S21>

The annealing step S2 has an accommodating step S21 of accommodating the SiC substrate 1 inside the crucible 2.

The accommodating step S21 includes accommodating the SiC substrate 1 inside the crucible 2 by putting the SiC substrate 1 through the opening of the base body 21 and placing the lid 22 on the base body 21 to cover the opening of the base body 21.

The accommodating step S21 includes making one surface 11 directly face the inner wall of the crucible 2 and making the other surface 11 directly face the inner wall of the crucible 2 by supporting the SiC substrate 1 in midair inside the crucible 2 with the substrate support 3. The accommodating step S21 includes supporting the SiC substrate 1 by the substrate support 3 from below the C face 112 with the Si face 111 facing upward and the C face 112 facing downward. Here, the accommodating step S21 includes supporting the SiC substrate 1 by the substrate support 3 via a slight contact area. It is preferable that the accommodating step S21 includes forming a macroscopic flow of the source gas from the inner wall of the crucible 2 to the C face and a macroscopic flow of the source gas from the Si face 111 to the inner wall of the crucible 2 to be substantially the same by supporting the SiC substrate 1 in midair inside the crucible 2 and arranging the SiC substrate 1 in the approximate center of the inside of the crucible 2.

It is preferable that the accommodating step S21 includes accommodating the crucible 2 inside a heating furnace. Here, it is preferable that the heating furnace comprises a line capable of introducing an inert gas and a line capable of vacuum evacuation.

It is preferable that a member containing a material other than SiC is not arranged inside the crucible 2. More specifically, it is preferable that a member other than the SiC substrate 1 is not arranged inside the crucible 2. When the substrate support 3 is formed separately from the base body 21 or the lid 22, it is preferable that a member other than the SiC substrate 1 and the substrate support 3 made of SiC is not arranged inside the crucible 2. Thereby, the environment inside the crucible 2 can be suitably maintained during heating.

For example, it is preferable that a heat source is not arranged inside the crucible 2. Thereby, it is possible to prevent impurities derived from the heat source from mixing into the environment inside the crucible 2. Further, it is possible to prevent the closed environment inside the crucible 2 from being lost due to a feedthrough of the heat source.

The accommodating step S21 may include accommodating the crucible 2 inside the large crucible 4. Here, the accommodating step S21 includes accommodating the crucible 2 inside the large crucible 4 by putting the crucible 2 through the opening of the large base body 41 and placing the large lid 42 on the large base body 41 to cover the opening of the large base body 41.

### <Heating Step S22>

The annealing step S2 has a heating step S22 of heating the crucible 2 after the accommodating step S21. The heating step S22 includes heating the SiC substrate 1 accommodated inside the crucible 2 by heating the crucible 2.

The heating step S22 includes heating the crucible 2 and generating a source gas from the crucible 2 into the inside of the crucible 2.

The heating step S22 includes introducing an inert gas into the inside of the crucible 2 and maintaining a pressure inside the crucible 2 at 1 kPa or more (or more than 1 kPa). This pressure may be 5 kPa or more (or more than 5 kPa), may be 10 kPa or more (or more than 10 kPa), or may be 100 kPa or more (or more than 100 kPa). Although there is no particular upper limit to this pressure, it is preferably 300 kPa or less (or less than 300 kPa). Here, the heating step S22 includes introducing the inert gas into the inside of the crucible 2 accommodated inside a heating furnace by introducing the inert gas into the inside of the heating furnace.

The heating step S22 includes heating the crucible 2 and maintaining a temperature inside the crucible 2 at 1800°C or more (or more than 1800°C). This temperature is preferably 1900°C or more (or more than 1900°C), preferably 2000°C or more (or more than 2000°C), preferably 2100°C or more (or more than 2100°C), and preferably 2200°C or more (or more than 2200°C). Although there is no particular upper limit to this temperature, it is preferably 2300°C or less (or less than 2300°C).

The heating step S22 includes maintaining a combination of the pressure and the temperature inside the crucible 2 at a combination of 1 kPa or more (or more than 1 kPa) and 1800°C or more (or more than 1800°C). This combination is preferably a combination of 1 kPa or more (or more than 1 kPa) and 1900°C or more (or more than 1900°C), and preferably a combination of 1 kPa or more (or more than 1 kPa) and 2000°C or more (or more than 2000°C). This combination is preferably a combination of 10 kPa or more (or more than 10 kPa) and 1800°C or more (or more than 1800°C), preferably a combination of 10 kPa or more (or more than 10 kPa) and 1900°C or more (or more than 1900°C), and preferably a combination of 10 kPa or more (or more than 10 kPa) and 2000°C or more (or more than 2000°C).

In the heating step S22, a particularly preferred combination of the pressure and the temperature inside the crucible 2 is a combination of 5 kPa or more (or more than 5 kPa) and 2000°C or more (or more than 2000°C). This combination is preferably a combination of 5 kPa or more (or more than 5 kPa) and 2200°C or more (or more than 2200°C), preferably a combination of 10 kPa or more (or more than 10 kPa) and 2000°C or more (or more than 2200°C), and preferably a combination of 10 kPa or more (or more than 10 kPa) and 2200°C or more (or more than 2200°C).

In the heating step S22, a heating time of the crucible 2 is 10 minutes or more (or more than 10 minutes). This heating time is preferably 30 minutes or more (or more than 30 minutes), and preferably 1 hour or more (or more than 1 hour). Although there is no particular upper limit to this time, it is preferably 3 hours or less (or less than 3 hours), and preferably 2 hours or less (or less than 2 hours).

The heating step S22 includes forming a macroscopic flow of the source gas inside the crucible 2 by forming a temperature gradient inside the crucible 2 in a direction penetrating the SiC substrate 1. Here, it is preferable that the heating step S22 includes forming the temperature gradient inside the crucible 2 by forming a temperature difference between the base body 21 and the lid 22. Note that although SiC is a material with high thermal conductivity, since a contact portion between the base body 21 and the lid 22 serves as a thermal resistance, a situation where a temperature difference is formed between the base body 21 and the lid 22 can be realized. This temperature difference is formed such that the base body 21 is at a high temperature and the lid 22 is at a low temperature. Thereby, the temperature gradient is formed in a sense such that the temperature decreases from the C face 112 side toward the Si face 111 side, and as a result, the Si face 111 can be etched and, at the same time, the C face 112 can be grown. Note that this temperature difference may be formed such that the base body 21 is at a low temperature and the lid 22 is at a high temperature. Thereby, the temperature gradient is formed in a sense such that the temperature decreases from the Si face 111 side toward the C face 112 side, and as a result, the Si face 111 can be grown and, at the same time, the C face 112 can be etched.

The heating step S22 includes heating the crucible 2 using a heating furnace as a heat source. Thereby, the inside of the crucible 2 can be heated from the outside of the crucible 2. Further, a desired temperature gradient can be formed inside the crucible 2 by making a difference in heating output between an upper part and a lower part of the heating furnace.

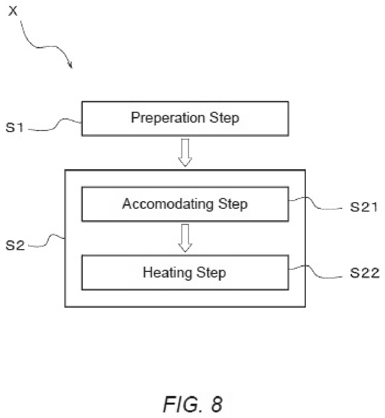

A flow of Processing Method X is as shown in Fig. 8. Processing Method X includes performing the preparation step S1, and subsequently performing the annealing step S2. The annealing step S2 includes performing the accommodating step S21, and subsequently performing the heating step S22. Note that Processing Method X may comprise a step of performing arbitrary processing after the annealing step S2. Here, it is preferable that Processing Method X does not comprise a step of performing mechanical processing after the annealing step S2.

### <Processing Method Y>

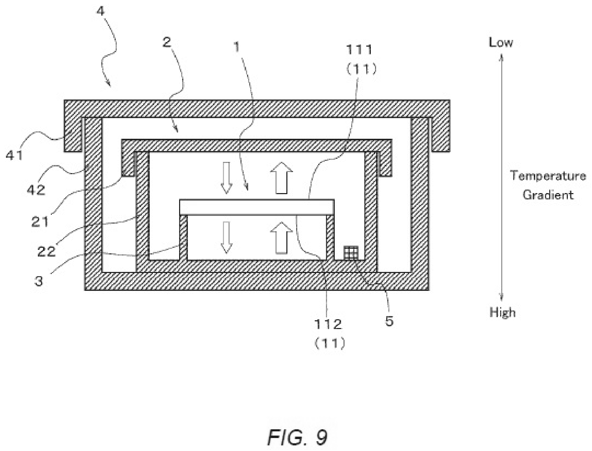

The second preferred mode of this processing method will be described in detail with reference to Figs. 9 to 10. In Figs. 9 to 10, configurations similar to the configurations shown in Figs. 1 to 8 are denoted by the same reference signs. Hereinafter, the second preferred mode of this processing method is referred to as Processing Method Y.

### <Preparation Step S1>

Processing Method Y comprises a preparation step S1 of preparing a SiC substrate 1. Since the preparation step S1 is similar to the preparation step S1 of Processing Method X, description thereof is omitted.

### <Annealing Step S2>

Processing Method Y comprises an annealing step S2 of annealing the SiC substrate 1 inside the crucible 2 made of SiC. Since the annealing step S2 is similar to the annealing step S2 of Processing Method X, description thereof is omitted.

### <Etching Step S3>

Processing Method Y comprises an etching step S3 of etching the SiC substrate 1 that has undergone the annealing step S2.

The etching in the etching step S3 is one in which a macroscopic decrease of atoms occurs by repeated microscopic decrease of atoms, similar to conventional etching. That is, it is different from the etching in the annealing step S2. At this time, the surface 11 of the SiC substrate 1 is precisely etched, and a SiC substrate 1 having significantly small surface roughness is realized.

The form of member arrangement is substantially the same as the form of the annealing step S2, but as shown in Fig. 7, it is preferable that a large crucible 4 is used in addition to the SiC substrate 1, the crucible 2, and the substrate support 3.

The inside of the crucible 2 is maintained in a source gas phase equilibrium environment. The term "source gas phase equilibrium environment" refers to an environment having a source gas pressure such that the SiC substrate and the source gas are in substantial phase equilibrium. Examples of the source gas phase equilibrium environment include a SiC-C equilibrium vapor pressure environment where C element is dominant and a SiC-Si equilibrium vapor pressure environment where Si element is dominant. That is, the etching step of this processing method can be said to be a step of etching the SiC substrate under the source gas phase equilibrium environment.

The temperature inside the crucible 2 maintained in the SiC-C equilibrium vapor pressure environment is preferably 1600°C or more (or more than 1600°C), and preferably 1700°C or more (or more than 1700°C). This temperature is preferably 2000°C or less (or less than 2000°C), and preferably 1900°C or less (or less than 1900°C). It is preferable that this temperature is lower than the temperature inside the crucible 2 in the annealing step S2.

The temperature inside the crucible 2 maintained in the SiC-Si equilibrium vapor pressure environment is preferably 1800°C or more (or more than 1800°C), and preferably 1900°C or more (or more than 1900°C). This temperature is preferably 2000°C or less (or less than 2000°C). It is preferable that this temperature is lower than the temperature inside the crucible 2 in the annealing step S2.

As shown in Fig. 9, when a Si gas source 5 (for example, a Si piece) is arranged inside the crucible 2, a SiC-Si equilibrium vapor pressure environment is formed inside the crucible 2. On the other hand, as shown in Fig. 7, when the Si gas source 5 is not arranged inside the crucible 2, a SiC-C equilibrium vapor pressure environment is formed inside the crucible 2.

A temperature gradient is formed inside the crucible 2. The magnitude of this temperature gradient is 0.1 mm/K or more and 5 mm/K or less. This temperature gradient is formed in a direction penetrating the SiC substrate 1. This temperature gradient is formed in a sense such that the temperature decreases from the C face 112 toward the Si face 111.

In Processing Method Y, since the inside of the crucible 2 is maintained in the source gas phase equilibrium environment in the form described above, etching of the Si face 111 can be performed under suitable conditions.

The recrystallization reaction is gently balanced and slightly biased toward the sublimation reaction, and the source gas gradually sublimates from the Si face 111. As a result, the Si face 111 can be precisely etched, and the surface roughness of the Si face 111 can be significantly reduced.

Hereinafter, steps included in the etching step S3 will be described in detail.

### <Etching Accommodating Step S31>

The etching step S3 has an etching accommodating step S31 of accommodating the SiC substrate 1 inside the crucible 2. The etching accommodating step S31 is substantially similar to the accommodating step S21 of Processing Method X, but includes not arranging the Si gas source 5 inside the crucible 2 as shown in Fig. 7 when etching under a SiC-C equilibrium vapor pressure environment, and includes arranging the Si gas source 5 inside the crucible 2 as shown in Fig. 9 when etching the SiC substrate under a SiC-Si equilibrium vapor pressure environment. Note that in the etching accommodating step S31, the crucible 2 may be the one used in the accommodating step S21 or may be a different one. Here, the etching accommodating step S31 may include preparing the crucible 2 that has undergone the annealing step S2 as it is, in a state where the SiC substrate 1 remains accommodated, instead of accommodating the SiC substrate 1 inside the crucible 2.

### <Etching Heating Step S32>

The etching step S3 has an etching heating step S32 of heating the crucible 2 after the etching accommodating step S31. The etching heating step S32 includes heating the SiC substrate 1 accommodated inside the crucible 2 by heating the crucible 2.

It is preferable that the etching heating step S32 includes maintaining the inside of the crucible 2 in a SiC-C equilibrium vapor pressure environment. Here, it is preferable that the etching heating step S32 maintains the inside of the crucible 2 in the SiC-C equilibrium vapor pressure environment by heating the crucible 2 while evacuating the inside of the crucible 2, and generating a source gas from the crucible 2 into the inside of the crucible 2.

When maintaining the inside of the crucible 2 in the SiC-C equilibrium vapor pressure environment, the etching heating step S32 includes heating the crucible 2 and maintaining a temperature inside the crucible 2 at 1600°C or more (or more than 1600°C). This temperature is preferably 1700°C or more (or more than 1700°C). This temperature is 2000°C or less (or less than 2000°C). This temperature is preferably 1900°C or less (or less than 1900°C). It is preferable that this temperature is lower than the temperature inside the crucible 2 in the heating step S22.

It is also preferable that the etching heating step S32 includes maintaining the inside of the crucible 2 in a SiC-Si equilibrium vapor pressure environment. Here, it is preferable that the etching heating step S32 maintains the inside of the crucible 2 in the SiC-Si equilibrium vapor pressure environment by heating the crucible 2 while evacuating the inside of the crucible 2, generating a source gas from the crucible 2 into the inside of the crucible 2, and generating Si gas from the Si gas source 5 into the inside of the crucible 2.

When maintaining the inside of the crucible 2 in the SiC-Si equilibrium vapor pressure environment, the etching heating step S32 includes heating the crucible 2 and maintaining a temperature inside the crucible 2 at 1800°C or more (or more than 1800°C). This temperature is preferably 1900°C or more (or more than 1900°C). This temperature is 2000°C or less (or less than 2000°C). It is preferable that this temperature is lower than the temperature inside the crucible 2 in the heating step S22.

The etching heating step S32 includes forming a macroscopic flow of the source gas inside the crucible 2 by forming a temperature gradient inside the crucible 2 in a direction penetrating the SiC substrate 1. Here, the etching heating step S32 includes forming a temperature difference such that the base body 21 is at a high temperature and the lid 22 is at a low temperature. Thereby, a temperature gradient is formed in a sense such that the temperature decreases from the C face 112 side toward the Si face 111 side, and as a result, the Si face 111 can be precisely etched.

The etching heating step S32 includes heating the crucible 2 using a heating furnace as a heat source. Thereby, the inside of the crucible 2 can be heated from the outside of the crucible 2. Further, a desired temperature gradient can be formed inside the crucible 2 by making a difference in heating output between an upper part and a lower part of the heating furnace.

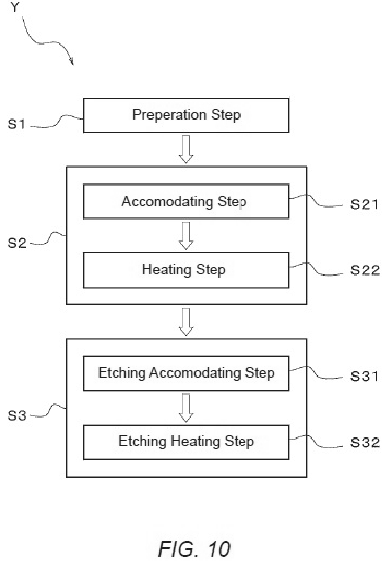

A flow of Processing Method Y is as shown in Fig. 10. Processing Method Y includes performing the preparation step S1, subsequently performing the annealing step S2, and subsequently performing the etching step S3. The annealing step S2 includes performing the accommodating step S21, and subsequently performing the heating step S22. The etching step S3 includes performing the etching accommodating step S31, and subsequently performing the etching heating step S32. Note that Processing Method Y may comprise a step of performing arbitrary processing after the etching step S3. Here, it is preferable that Processing Method Y does not comprise a step of performing mechanical processing after the etching step S3.

### <Processing Method Z>

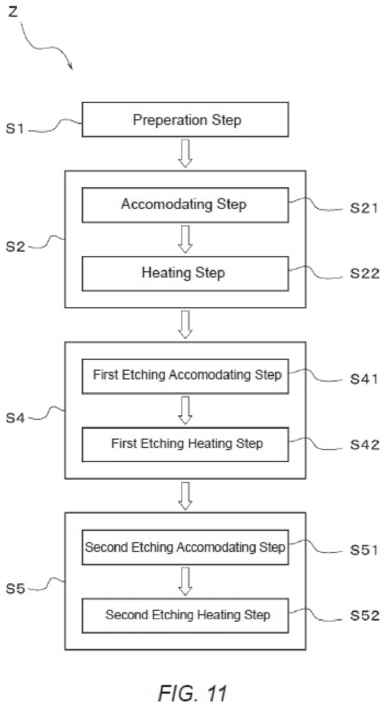

The third preferred mode of this processing method will be described in detail with reference to Fig. 11. In Fig. 11, configurations similar to the configurations shown in Figs. 1 to 10 are denoted by the same reference signs. Hereinafter, the third preferred mode of this processing method is referred to as Processing Method Z.

### <Preparation Step S1>

Processing Method Z comprises a preparation step S1 of preparing a SiC substrate 1. Since the preparation step S1 is similar to the preparation step S1 of Processing Method Y, description thereof is omitted.

### <Annealing Step S2>

Processing Method Z comprises an annealing step S2 of annealing the SiC substrate 1 inside the crucible 2 made of SiC. Since the annealing step S2 is similar to the annealing step S2 of Processing Method Y, description thereof is omitted.

### <First Etching Step S4>

Processing Method Z comprises a first etching step S4 of etching the SiC substrate 1 that has undergone the annealing step S2. The first etching step S4 is substantially similar to the etching step S3 of Processing Method Y, but the inside of the crucible 2 is maintained in a SiC-C equilibrium vapor pressure environment.

### <First Etching Accommodating Step S41>

The first etching step S4 has a first etching accommodating step S41 of accommodating the SiC substrate 1 inside the crucible 2. The first etching accommodating step S41 is substantially similar to the etching accommodating step S31 of Processing Method Y, but includes not arranging the Si gas source 5 inside the crucible 2 as shown in Fig. 7.

### <First Etching Heating Step S42>

The first etching step S4 has a first etching heating step S42 of heating the crucible 2 after the first etching accommodating step S41. The first etching heating step S42 is substantially similar to the etching heating step S32 of Processing Method Y, but includes maintaining the inside of the crucible 2 in the SiC-C equilibrium vapor pressure environment.

### <Second Etching Step S5>

Processing Method Z comprises a second etching step S5 of further etching the SiC substrate 1 that has undergone the first etching step S4. The second etching step S5 is substantially similar to the etching step S3 of Processing Method Y, but the inside of the crucible 2 is maintained in a SiC-Si equilibrium vapor pressure environment.

### <Second Etching Accommodating Step S51>

The second etching step S5 has a second etching accommodating step S51 of accommodating the SiC substrate 1 inside the crucible 2. The second etching accommodating step S51 is substantially similar to the etching accommodating step S31 of Processing Method Y, but includes arranging the Si gas source 5 inside the crucible 2 as shown in Fig. 9.

### <Second Etching Heating Step S52>

The second etching step S5 has a second etching heating step S52 of heating the crucible 2 after the second etching accommodating step S51. The second etching heating step S52 is substantially similar to the etching heating step S32 of Processing Method Y, but includes maintaining the inside of the crucible 2 in the SiC-Si equilibrium vapor pressure environment.

In Processing Method Z, by etching the SiC substrate 1 under the SiC-C equilibrium vapor pressure environment in the first etching step S4 and thereafter etching the SiC substrate 1 under the SiC-Si equilibrium vapor pressure environment in the second etching step S5 in the form described above, the Si face 111 can be etched more precisely, and the surface roughness of the Si face can be further significantly reduced (in particular, macro-step bunching on the Si face can be decomposed).

A flow of Processing Method Z is as shown in Fig. 11. Processing Method Z includes performing the preparation step S1, subsequently performing the annealing step S2, subsequently performing the first etching step S4, and subsequently performing the second etching step S5. The annealing step S2 includes performing the accommodating step S21, and subsequently performing the heating step S22. The first etching step S4 includes performing the first etching accommodating step S41, and subsequently performing the first etching heating step S42. The second etching step S5 includes performing the second etching accommodating step S51, and subsequently performing the second etching heating step S52. Note that Processing Method Z may comprise a step of performing arbitrary processing after the second etching step S5. Here, it is preferable that Processing Method Z does not comprise a step of performing mechanical processing after the second etching step S5.

### <Processing Method V>

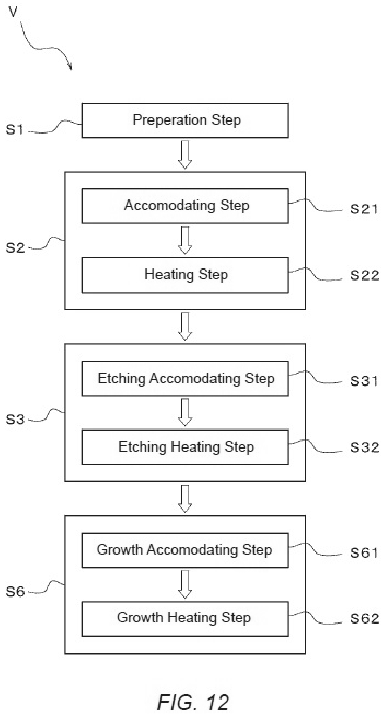

The fourth preferred mode of this processing method will be described in detail with reference to Fig. 12. In Fig. 12, configurations similar to the configurations shown in Figs. 1 to 11 are denoted by the same reference signs. Hereinafter, the fourth preferred mode of this processing method is referred to as Processing Method V.

### <Preparation Step S1>

Processing Method V comprises a preparation step S1 of preparing a SiC substrate 1. Since the preparation step S1 is similar to the preparation step S1 of Processing Method Z, description thereof is omitted.

### <Annealing Step S2>

Processing Method V comprises an annealing step S2 of annealing the SiC substrate 1 inside the crucible 2 made of SiC. Since the annealing step S2 is similar to the annealing step S2 of Processing Method Z, description thereof is omitted.

### <Etching Step S3>

Processing Method V comprises an etching step S3 of etching the SiC substrate 1 that has undergone the annealing step S2. Since the etching step S3 is similar to the etching step S3 of Processing Method Y, description thereof is omitted.

It is preferable that Processing Method V comprises a first etching step S4 and a second etching step S5 in this order as the etching step S3. Since the first etching step S4 and the second etching step S5 are similar to the first etching step S4 and the second etching step S5 of Processing Method Z, description thereof is omitted.

### <Growth Step S6>

Processing Method V comprises a growth step S6 of growing the SiC substrate 1 that has undergone the etching step S3.

The growth in the growth step S6 is one in which a macroscopic increase of atoms occurs by repeated microscopic increase of atoms, similar to conventional growth. That is, it is different from the growth in the annealing step S2. At this time, the surface 11 of the SiC substrate 1 grows precisely, and a SiC substrate 1 having significantly small surface roughness is realized.

The form of member arrangement is similar to the form of the etching step S3.

The inside of the crucible 2 is maintained in a source gas phase equilibrium environment. That is, the growth step of this processing method can be said to be a step of growing the SiC substrate under the source gas phase equilibrium environment.

The temperature inside the crucible 2 maintained in the SiC-C equilibrium vapor pressure environment is preferably 1600°C or more (or more than 1600°C), and preferably 1700°C or more (or more than 1700°C). This temperature is preferably 2000°C or less (or less than 2000°C), and preferably 1900°C or less (or less than 1900°C). It is preferable that this temperature is lower than the temperature inside the crucible 2 in the annealing step S2.

The temperature inside the crucible 2 maintained in the SiC-Si equilibrium vapor pressure environment is preferably 1800°C or more (or more than 1800°C), and preferably 1900°C or more (or more than 1900°C). This temperature is preferably 2000°C or less (or less than 2000°C). It is preferable that this temperature is lower than the temperature inside the crucible 2 in the annealing step S2.

A temperature gradient is formed inside the crucible 2. The magnitude of this temperature gradient is 0.1 mm/K or more and 5 mm/K or less. This temperature gradient is formed in a direction penetrating the SiC substrate 1. This temperature gradient is formed in a sense such that the temperature decreases from the Si face 111 toward the C face 112.

In Processing Method V, since the inside of the crucible 2 is maintained in the source gas phase equilibrium environment in the form described above, growth of the Si face 111 can be performed under suitable conditions.

Since the inside of the crucible 2 is maintained in the source gas phase equilibrium environment as described above, the sublimation reaction and the recrystallization reaction are gently balanced and slightly biased toward the recrystallization reaction, and the source gas gradually recrystallizes on the Si face 111. As a result, the Si face 111 can be grown precisely, and an increase in surface roughness of the Si face 111 can be significantly suppressed.

Hereinafter, steps included in the growth step S6 will be described in detail.

### <Growth Accommodating Step S61>

The growth step S6 has a growth accommodating step S61 of accommodating the SiC substrate 1 inside the crucible 2. The growth accommodating step S61 is similar to the etching accommodating step S31 of Processing Method Y. Note that in the growth accommodating step S61, the crucible 2 may be the one used in the accommodating step S21, may be the one used in the etching accommodating step S31, or may be a different one. Here, the growth accommodating step S61 may include preparing the crucible 2 that has undergone the etching step S3 as it is, in a state where the SiC substrate 1 remains accommodated, instead of accommodating the SiC substrate 1 inside the crucible 2.

### <Growth Heating Step S62>

The growth step S6 has a growth heating step S62 of heating the crucible 2 after the growth accommodating step S61. The growth heating step S62 includes heating the SiC substrate 1 accommodated inside the crucible 2 by heating the crucible 2.

It is preferable that the growth heating step S62 includes maintaining the inside of the crucible 2 in a SiC-C equilibrium vapor pressure environment. Here, it is preferable that the growth heating step S62 maintains the inside of the crucible 2 in the SiC-C equilibrium vapor pressure environment by heating the crucible 2 while evacuating the inside of the crucible 2, and generating a source gas from the crucible 2 into the inside of the crucible 2.

When maintaining the inside of the crucible 2 in the SiC-C equilibrium vapor pressure environment, the growth heating step S62 includes heating the crucible 2 and maintaining a temperature inside the crucible 2 at 1600°C or more (or more than 1600°C). This temperature is preferably 1700°C or more (or more than 1700°C). This temperature is 2000°C or less (or less than 2000°C). This temperature is preferably 1900°C or less (or less than 1900°C). It is preferable that this temperature is lower than the temperature inside the crucible 2 in the heating step S22.

It is also preferable that the growth heating step S62 includes maintaining the inside of the crucible 2 in a SiC-Si equilibrium vapor pressure environment. Here, it is preferable that the growth heating step S62 maintains the inside of the crucible 2 in the SiC-Si equilibrium vapor pressure environment by heating the crucible 2 while evacuating the inside of the crucible 2, generating a source gas from the crucible 2 into the inside of the crucible 2, and generating Si gas from the Si gas source 5 into the inside of the crucible 2.

When maintaining the inside of the crucible 2 in the SiC-Si equilibrium vapor pressure environment, the growth heating step S62 includes heating the crucible 2 and maintaining a temperature inside the crucible 2 at 1800°C or more (or more than 1800°C). This temperature is preferably 1900°C or more (or more than 1900°C). This temperature is 2000°C or less (or less than 2000°C). It is preferable that this temperature is lower than the temperature inside the crucible 2 in the heating step S22.

The growth heating step S62 includes forming a macroscopic flow of the source gas inside the crucible 2 by forming a temperature gradient inside the crucible 2 in a direction penetrating the SiC substrate 1. Here, the growth heating step S62 includes forming a temperature difference such that the base body 21 is at a low temperature and the lid 22 is at a high temperature. Thereby, a temperature gradient is formed in a sense such that the temperature decreases from the Si face 111 side toward the C face 112 side, and as a result, the Si face 111 can be grown precisely.

The growth heating step S62 includes heating the crucible 2 using a heating furnace as a heat source. Thereby, the inside of the crucible 2 can be heated from the outside of the crucible 2. Further, a desired temperature gradient can be formed inside the crucible 2 by making a difference in heating output between an upper part and a lower part of the heating furnace.

A flow of Processing Method V is as shown in Fig. 12. Processing Method V includes performing the preparation step S1, subsequently performing the annealing step S2, subsequently performing the etching step S3, and subsequently performing the growth step S6. The annealing step S2 includes performing the accommodating step S21, and subsequently performing the heating step S22. The etching step S3 includes performing the etching accommodating step S31, and subsequently performing the etching heating step S32. The growth step S6 includes performing the growth accommodating step S61, and subsequently performing the growth heating step S62. Note that Processing Method V may comprise a step of performing arbitrary processing after the growth step S6. Here, it is preferable that Processing Method V does not comprise a step of performing mechanical processing after the growth step S6.

### <Processing Method W>

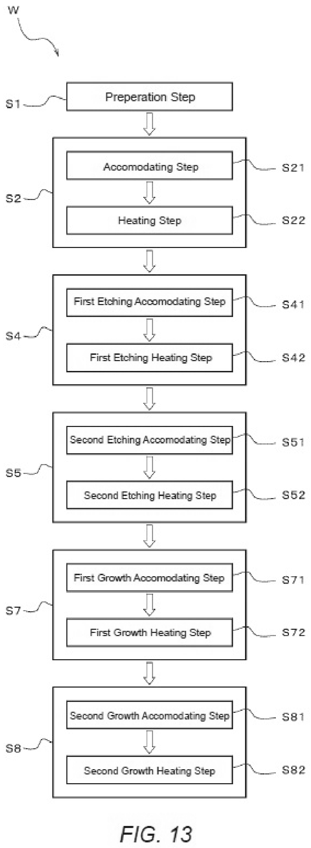

The fifth preferred mode of this processing method will be described in detail with reference to Fig. 13. In Fig. 13, configurations similar to the configurations shown in Figs. 1 to 12 are denoted by the same reference signs. Hereinafter, the fifth preferred mode of this processing method is referred to as Processing Method W.

### <Preparation Step S1>

Processing Method W comprises a preparation step S1 of preparing a SiC substrate 1. Since the preparation step S1 is similar to the preparation step S1 of Processing Method V, description thereof is omitted.

### <Annealing Step S2>

Processing Method W comprises an annealing step S2 of annealing the SiC substrate 1 inside the crucible 2 made of SiC. Since the annealing step S2 is similar to the annealing step S2 of Processing Method V, description thereof is omitted.

### <First Etching Step S4>

Processing Method W comprises a first etching step S4 of etching the SiC substrate 1 that has undergone the annealing step S2. Since the first etching step S4 is similar to the first etching step S4 of Processing Method Z, description thereof is omitted.

### <Second Etching Step S5>

Processing Method W comprises a second etching step S5 of further etching the SiC substrate 1 that has undergone the first etching step S4. Since the second etching step S5 is similar to the second etching step S5 of Processing Method Z, description thereof is omitted.

### <First Growth Step S7>

Processing Method W comprises a first growth step S7 of growing the SiC substrate 1 that has undergone the second etching step S5. The first growth step S7 is substantially similar to the growth step S6 of Processing Method V, but the inside of the crucible 2 is maintained in a SiC-C equilibrium vapor pressure environment.

### <First Growth Accommodating Step S71>

The first growth step S7 has a first growth accommodating step S71 of accommodating the SiC substrate 1 inside the crucible 2. The first growth accommodating step S71 is substantially similar to the growth accommodating step S61 of Processing Method V, but includes not arranging the Si gas source 5 inside the crucible 2 as shown in Fig. 7.

### <First Growth Heating Step S72>

The first growth step S7 has a first growth heating step S72 of heating the crucible 2 after the first growth accommodating step S71. The first growth heating step S72 is substantially similar to the growth heating step S62 of Processing Method V, but includes maintaining the inside of the crucible 2 in the SiC-C equilibrium vapor pressure environment.

### <Second Growth Step S8>

Processing Method W comprises a second growth step S8 of further growing the SiC substrate 1 that has undergone the first growth step S7. The second growth step S8 is substantially similar to the growth step S6 of Processing Method V, but the inside of the crucible 2 is maintained in a SiC-Si equilibrium vapor pressure environment.

### <Second Growth Accommodating Step S81>

The second growth step S8 has a second growth accommodating step S81 of accommodating the SiC substrate 1 inside the crucible 2. The second growth accommodating step S81 is substantially similar to the growth accommodating step S61 of Processing Method V, but includes arranging the Si gas source 5 inside the crucible 2 as shown in Fig. 9.

### <Second Growth Heating Step S82>

The second growth step S8 has a second growth heating step S82 of heating the crucible 2 after the second growth accommodating step S81. The second growth heating step S82 is substantially similar to the growth heating step S62 of Processing Method V, but includes maintaining the inside of the crucible 2 in the SiC-Si equilibrium vapor pressure environment.

In Processing Method W, by etching the SiC substrate 1 under the SiC-Si equilibrium vapor pressure environment in the second etching step S5 and thereafter growing the SiC substrate 1 under the SiC-C equilibrium vapor pressure environment in the first growth step S7 in the form described above, inheritance of basal plane dislocations (BPD) to the growth layer can be significantly suppressed.

Further, in Processing Method W, by growing the SiC substrate 1 under the SiC-C equilibrium vapor pressure environment in the first growth step S7 and thereafter growing the SiC substrate 1 under the SiC-Si equilibrium vapor pressure environment in the second growth step S8 in the form described above, the surface roughness of the Si face can be significantly reduced (in particular, macro-step bunching on the Si face can be decomposed).

Generally, in Processing Method W, a SiC substrate in an arbitrary state can be processed into a SiC substrate suitable for SiC semiconductor device manufacturing, in which surface roughness is significantly suppressed, BPD is significantly suppressed, and the subsurface damaged layer causing in-grown stacking faults (IGSF) is significantly removed.

A flow of Processing Method W is as shown in Fig. 13. Processing Method Z includes performing the preparation step S1, subsequently performing the annealing step S2, subsequently performing the first etching step S4, subsequently performing the second etching step S5, subsequently performing the first growth step S7, and subsequently performing the second growth step S8. The annealing step S2 includes performing the accommodating step S21, and subsequently performing the heating step S22. The first etching step S4 includes performing the first etching accommodating step S41, and subsequently performing the first etching heating step S42. The second etching step S5 includes performing the second etching accommodating step S51, and subsequently performing the second etching heating step S52. The first growth step S7 includes performing the first growth accommodating step S71, and subsequently performing the first growth heating step S72. The second growth step S8 includes performing the second growth accommodating step S81, and subsequently performing the second growth heating step S82. Note that Processing Method W may comprise a step of performing arbitrary processing after the second growth step S8. Here, it is preferable that Processing Method W does not comprise a step of performing mechanical processing after the second growth step S8.

### Example 1

Processing Method X was performed according to the following steps.

### <Preparation Step S1>

A substrate with the following measured characteristics was prepared as the SiC substrate 1. Note that the SiC substrate 1 was cleaned with a chemical solution to eliminate the influence of the measurement on the surface 11.

Material: 4H-SiC
Off angle: 4°
Off direction: [11-20] direction
Size: 6 inches
Arithmetic mean roughness Ra of Si face 111: 46.2 nm
Substrate thickness: 400.0 µm

### <Annealing Step S2>

The SiC substrate 1 was annealed according to the following steps.

### <Accommodating Step S21>

As shown in Fig. 6, the SiC substrate 1 was accommodated inside the crucible 2 made of polycrystalline SiC.

### <Heating Step S22>

The SiC substrate 1 was heated under the following conditions.

Introduced gas: Ar gas
Pressure: 1 kPa or more and 300 kPa or less
Temperature: 1800°C or more and 2300°C or less
Temperature difference: Base body 21 is at a high temperature, lid 22 is at a low temperature
Time: 1 hour

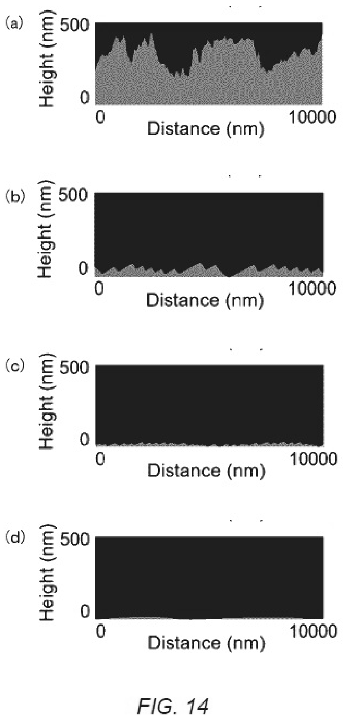

Fig. 14 shows profile lines based on AFM images (10 µm × 10 µm). In Fig. 12, (a) is the SiC substrate 1 prepared in the preparation step S1, and (b) is the SiC substrate 1 that has undergone the annealing step S2. From a comparison of the shapes of the profile lines, it was found that the surface roughness of the Si face 111 was reduced.

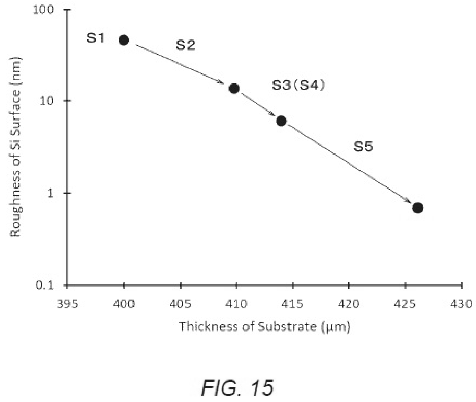

Fig. 15 shows a relationship between the arithmetic mean roughness Ra of the Si face 111 and the substrate thickness. The arithmetic mean roughness Ra of the Si face 111 was reduced from 46.2 nm to 13.7 nm by undergoing the annealing step S2. Further, the substrate thickness of the SiC substrate 1 increased from 400.0 µm to 409.8 µm by undergoing the annealing step S2. From this, it was found that the surface roughness of the Si face 111 was reduced while maintaining the substrate thickness of the SiC substrate 1 almost unchanged. From the condition of the temperature difference, it is considered that the Si face 111 was etched and, at the same time, the C face 112 was grown. Further, it is considered that the etching amount on the Si face 111 was substantially the same as or smaller than the growth amount on the C face 112.

### Example 2

Processing Method X was performed according to the following steps.

### <Preparation Step S1>

A substrate with the following measured characteristics was prepared as the SiC substrate 1. Note that the SiC substrate 1 was cleaned with a chemical solution to eliminate the influence of the measurement on the surface 11.

Material: 4H-SiC
Off angle: 4°
Off direction: [11-20] direction
Size: 6 inches
Arithmetic mean roughness Ra of Si face 111: 46.2 nm
Substrate thickness: 400.0 µm

### <Annealing Step S2>

The SiC substrate 1 was annealed according to the following steps.

### <Accommodating Step S21>

As shown in Fig. 6, the SiC substrate 1 was accommodated inside the crucible 2 made of polycrystalline SiC.

### <Heating Step S22>

The SiC substrate 1 was heated under the following conditions.

Introduced gas: Ar gas
Pressure: Any of vacuum (~10^-4 kPa), 5 kPa, and 10 kPa
Temperature: Any of 1800°C, 2000°C, and 2200°C
Temperature difference: Base body 21 is at a high temperature, lid 22 is at a low temperature
Time: 1 hour

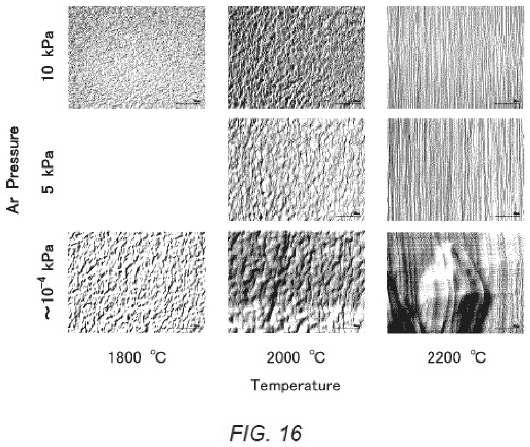

Fig. 16 shows laser microscope images of the Si face 111 for the SiC substrates processed based on each condition. It was found that compared to when the pressure was vacuum, a scale of irregularities on the surface became smaller when the pressure was 5 kPa or more. In addition, it was found that when the temperature was 2200°C or more, a step-terrace structure appeared on the surface, that is, the surface shape was regulated.

The arithmetic mean height Sa was 70 nm when the pressure was vacuum and 153 nm when the pressure was 10 kPa at a temperature of 1800°C; 174 nm when the pressure was vacuum, 71 nm when the pressure was 5 kPa, and 86 nm when the pressure was 10 kPa at a temperature of 2000°C; and 242 nm when the pressure was vacuum, 56 nm when the pressure was 5 kPa, and 54 nm when the pressure was 10 kPa at a temperature of 2200°C. From a comparison of the arithmetic mean height Sa, it was found that the surface roughness of the Si face 111 was clearly reduced when the pressure was 5 kPa or more. In addition, it was found that the surface roughness of the Si face 111 was significantly reduced when the temperature was 2000°C or more, and the surface roughness of the Si face 111 was further significantly reduced when the temperature was 2200°C or more.

### Example 3

Following Example 1, Processing Method Y was performed according to the following steps. Note that the SiC substrate 1 was cleaned with a chemical solution to eliminate the influence of the measurement on the surface 11.

### <Etching Step S3>

The SiC substrate 1 was etched according to the following steps.

### <Etching Accommodating Step S31>

As shown in Fig. 7, the SiC substrate 1 was accommodated inside the crucible 2.

### <Etching Heating Step S32>

The SiC substrate 1 was heated under the following conditions. At this time, the inside of the crucible 2 was in a SiC-C equilibrium vapor pressure environment.

Introduced gas: None
Pressure: Vacuum (source gas pressure)
Temperature: 1600°C or more and 2000°C or less (lower than the temperature in the heating step S22)
Temperature difference: Base body 21 is at a high temperature, lid 22 is at a low temperature
Time: 1 hour

In Fig. 14, (c) is the SiC substrate 1 that has undergone the etching step S3. From a comparison of the shapes of the profile lines, it was found that the surface roughness of the Si face 111 was further reduced.

The arithmetic mean roughness Ra of the Si face 111 was reduced from 13.7 nm to 6.1 nm by undergoing the etching step S3. Further, the substrate thickness of the SiC substrate 1 increased from 409.8 µm to 414.0 µm by undergoing the etching step S3. From this, it was found that the surface roughness of the Si face 111 was reduced while maintaining the substrate thickness of the SiC substrate 1 almost unchanged. From the condition of the temperature difference, it is considered that the Si face 111 was etched and, at the same time, the C face 112 was grown. Further, it is considered that the etching amount on the Si face 111 was substantially the same as or smaller than the growth amount on the C face 112.

### Example 4

Following Example 3, Processing Method Z was performed according to the following steps. However, the first etching step S4 of Processing Method Z is similar to the etching step S3 of Example 2. Note that the SiC substrate 1 was cleaned with a chemical solution to eliminate the influence of the measurement on the surface 11.

### <Second Etching Step S5>

The SiC substrate 1 was etched according to the following steps.

### <Second Etching Accommodating Step S51>

As shown in Fig. 9, the SiC substrate 1 was accommodated inside the crucible 2 together with the Si gas source 5.

### <Second Etching Heating Step S52>

The SiC substrate 1 was heated under the following conditions. At this time, the inside of the crucible 2 was in a SiC-Si equilibrium vapor pressure environment.

Introduced gas: None
Pressure: Vacuum (source gas pressure)
Temperature: 1800°C or more and 2000°C or less (lower than the temperature in the heating step S22 and higher than the temperature in the first etching heating step S42)
Temperature difference: Base body 21 is at a high temperature, lid 22 is at a low temperature
Time: 1 hour

In Fig. 14, (d) is the SiC substrate 1 that has undergone the second etching step S5. From a comparison of the shapes of the profile lines, it was found that the surface roughness of the Si face 111 was further reduced.

The arithmetic mean roughness Ra of the Si face 111 was reduced from 6.1 nm to 0.7 nm by undergoing the second etching step S5. Further, the substrate thickness of the SiC substrate 1 increased from 414.0 µm to 426.1 µm by undergoing the second etching step S5. From this, it was found that the surface roughness of the Si face 111 was reduced while maintaining the substrate thickness of the SiC substrate 1 almost unchanged. From the condition of the temperature difference, it is considered that the Si face 111 was etched and, at the same time, the C face 112 was grown. Further, it is considered that the etching amount on the Si face 111 was substantially the same as or smaller than the growth amount on the C face 112.

### Example 5

Processing Method V was performed according to the following steps.

### <Preparation Step S1>

A substrate with the following measured characteristics was prepared as the SiC substrate 1. Note that the SiC substrate 1 was cleaned with a chemical solution to eliminate the influence of the measurement on the surface 11.

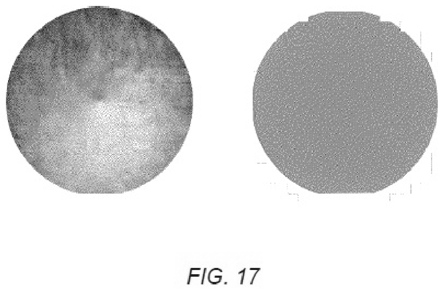

Material: 4H-SiC
Off angle: 4°
Off direction: direction
Size: 3 inches
Arithmetic mean roughness Ra of Si face 111: 60 nm or more
Photoluminescence image of Si face 111: Fig. 17 left

### <Annealing Step S2>

The SiC substrate 1 was annealed according to the following steps.

### <Accommodating Step S21>

As shown in Fig. 6, the SiC substrate 1 was accommodated inside the crucible 2 made of polycrystalline SiC.

### <Heating Step S22>

The SiC substrate 1 was heated under the following conditions.

Introduced gas: Ar gas
Pressure: 10 kPa
Temperature: 2200°C
Temperature difference: Base body 21 is at a high temperature, lid 22 is at a low temperature
Time: 1 hour

### <First Etching Step S4>

The SiC substrate 1 was etched according to the following steps.

### <First Etching Accommodating Step S41>

As shown in Fig. 7, the SiC substrate 1 was accommodated inside the crucible 2.

### <First Etching Heating Step S42>

The SiC substrate 1 was heated under the following conditions. At this time, the inside of the crucible 2 was in a SiC-C equilibrium vapor pressure environment.

Introduced gas: None
Pressure: Vacuum (source gas pressure)
Temperature: 1800°C
Temperature difference: Base body 21 is at a high temperature, lid 22 is at a low temperature
Time: 1 hour

### <Second Etching Step S5>

The SiC substrate 1 was etched according to the following steps.

### <Second Etching Accommodating Step S51>

As shown in Fig. 9, the SiC substrate 1 was accommodated inside the crucible 2.

### <Second Etching Heating Step S52>

The SiC substrate 1 was heated under the following conditions. At this time, the inside of the crucible 2 was in a SiC-Si equilibrium vapor pressure environment.

Introduced gas: None
Pressure: Vacuum (source gas pressure)
Temperature: 1800°C
Temperature difference: Base body 21 is at a high temperature, lid 22 is at a low temperature
Time: 1 hour

### <Growth Step S6>

The SiC substrate 1 was grown according to the following steps.

### <Growth Accommodating Step S61>

As shown in Fig. 7, the SiC substrate 1 was accommodated inside the crucible 2.

### <Growth Heating Step S62>

The SiC substrate 1 was heated under the following conditions. At this time, the inside of the crucible 2 was in a SiC-C equilibrium vapor pressure environment.

Introduced gas: None
Pressure: Vacuum (source gas pressure)
Temperature: 1800°C
Temperature difference: Base body 21 is at a high temperature, lid 22 is at a low temperature
Time: 2 hours

The arithmetic mean roughness Ra of the Si face 111 became less than 5 nm. In addition, the photoluminescence image of the Si face 111 became as shown in Fig. 17 right. Note that on the entire surface of the SiC substrate 1, BPD was 3 (number density was 0.07 cm^-2) and IGSF was 12 (number density was 0.27 cm^-2). That is, it was found that the surface roughness of the Si face 111 was reduced, and BPD and IGSF were mostly removed.

### Reference Signs List

X: Processing method
S2: Annealing step
S21: Accommodating step
S22: Heating step
1: SiC substrate
11: Surface
111: Si face
112: C face
12: Subsurface damaged layer
2: Crucible
21: Base body
22: Lid
3: Substrate support
d: Depth

## Claims

1. A processing method for a SiC substrate, comprising an annealing step of heating the SiC substrate in an inert gas environment and
an etching step of etching the SiC substrate that has undergone the annealing step in an environment including a gas composed of one or both of Si element and C element.

2. The processing method for a SiC substrate according to claim 1, wherein the annealing step includes heating the SiC substrate inside a crucible made of SiC, and
in the annealing step, the inside of the crucible is maintained in an inert gas environment.

3. The processing method for a SiC substrate according to claim 1 or 2, wherein the annealing step includes etching one surface of the SiC substrate and, at the same time, growing the other surface of the SiC substrate.

4. The processing method for a SiC substrate according to claim 3, wherein the annealing step includes making a substrate thickness of the SiC substrate substantially the same before and after the annealing step by making an etching amount on one surface substantially the same as a growth amount on the other surface.

5. The processing method for a SiC substrate according to claim 3 or 4, wherein the annealing step includes increasing a substrate thickness of the SiC substrate before and after the annealing step by making an etching amount on one surface smaller than a growth amount on the other surface.

6. The processing method for a SiC substrate according to any one of claims 2 to 5, wherein in the annealing step, a pressure inside the crucible is 5 kPa or more.

7. The processing method for a SiC substrate according to any one of claims 2 to 5, wherein in the annealing step, a pressure inside the crucible is 10 kPa or more.

8. The processing method for a SiC substrate according to any one of claims 2 to 7, wherein in the annealing step, a temperature inside the crucible is 2000°C or more.

9. The processing method for a SiC substrate according to any one of claims 2 to 7, wherein in the annealing step, a temperature inside the crucible is 2200°C or more.

10. The processing method for a SiC substrate according to any one of claims 2 to 9, wherein in the annealing step, a combination of pressure and temperature inside the crucible is a combination of 5 kPa or more and 2000°C or more.

11. The processing method for a SiC substrate according to any one of claims 2 to 9, wherein in the annealing step, a combination of pressure and temperature inside the crucible is a combination of 5 kPa or more and 2200°C or more.

12. The processing method for a SiC substrate according to any one of claims 1 to 11, wherein in the annealing step, a protective film is not formed on the surface of the SiC substrate.

13. The processing method for a SiC substrate according to any one of claims 1 to 12, wherein the etching step includes heating the SiC substrate inside a crucible made of SiC, and
in the etching step, the inside of the crucible is maintained in an environment including a gas composed of one or both of Si element and C element.

14. The processing method for a SiC substrate according to claim 13, wherein in the etching step, the inside of the crucible is maintained in a SiC-C equilibrium vapor pressure environment.

15. The processing method for a SiC substrate according to claim 13, wherein in the etching step, the inside of the crucible is maintained in a SiC-Si equilibrium vapor pressure environment.

16. The processing method for a SiC substrate according to any one of claims 13 to 15, wherein in the etching step, a temperature gradient is formed inside the crucible in a direction penetrating the SiC substrate and in a sense such that the temperature decreases from a C face side toward a Si face side of the SiC substrate.

17. The processing method for a SiC substrate according to any one of claims 13 to 16, not comprising a step of performing mechanical processing on the SiC substrate after the etching step.

18. The processing method for a SiC substrate according to any one of claims 13 to 17, wherein the etching step is performed at least twice, a first etching step and a second etching step,
the first etching step includes etching the SiC substrate that has undergone the annealing step,
the second etching step includes etching the SiC substrate that has undergone the first etching step,
in the first etching step, the inside of the crucible is maintained in a SiC-C equilibrium vapor pressure environment, and
in the second etching step, the inside of the crucible is maintained in a SiC-Si equilibrium vapor pressure environment.

19. The processing method for a SiC substrate according to any one of claims 1 to 18, comprising a growth step of growing the SiC substrate that has undergone the etching step in an environment including a gas composed of one or both of Si element and C element.

20. The processing method for a SiC substrate according to claim 19, wherein the growth step includes heating the SiC substrate inside a crucible made of SiC, and
in the growth step, the inside of the crucible is maintained in an environment including a gas composed of one or both of Si element and C element.

21. The processing method for a SiC substrate according to claim 20, wherein in the growth step, the inside of the crucible is maintained in a SiC-C equilibrium vapor pressure environment.

22. The processing method for a SiC substrate according to claim 20, wherein in the growth step, the inside of the crucible is maintained in a SiC-Si equilibrium vapor pressure environment.

23. The processing method for a SiC substrate according to any one of claims 20 to 22, wherein in the growth step, a temperature gradient is formed inside the crucible in a direction penetrating the SiC substrate and in a sense such that the temperature decreases from a Si face side toward a C face side of the SiC substrate.

24. The processing method for a SiC substrate according to any one of claims 20 to 23, wherein the growth step is performed at least twice, a first growth step and a second growth step,
the first growth step includes growing the SiC substrate that has undergone the etching step,
the second growth step includes growing the SiC substrate that has undergone the first growth step,
in the first growth step, the inside of the crucible is maintained in a SiC-C equilibrium vapor pressure environment, and
in the second growth step, the inside of the crucible is maintained in a SiC-Si equilibrium vapor pressure environment.

25. A method for removing a subsurface damaged layer of a SiC substrate, comprising performing the processing method according to any one of claims 1 to 24 on a SiC substrate having a subsurface damaged layer to remove the subsurface damaged layer.

26. The method for removing a subsurface damaged layer of a SiC substrate according to claim 25, comprising performing the processing method on the SiC substrate on which the subsurface damaged layer has been formed by mechanical processing.

27. The method for removing a subsurface damaged layer of a SiC substrate according to claim 25 or 26, wherein the annealing step includes exchanging atoms between a surface layer of the SiC substrate and the inert gas environment to remove the subsurface damaged layer.

28. A method for reducing surface roughness of a SiC substrate, comprising performing the processing method according to any one of claims 1 to 24 on a SiC substrate having an Si face with an arithmetic mean roughness Ra of 15 nm or more to reduce the arithmetic mean roughness Ra.

29. The method for reducing surface roughness of a SiC substrate according to claim 28, comprising performing the processing method on the SiC substrate that has undergone mechanical processing.

30. The method for reducing surface roughness of a SiC substrate according to claim 28 or 29, wherein the annealing step includes exchanging atoms between a surface layer of the SiC substrate and the inert gas environment to level the surface layer.
